(19) Europäisches Patentamt
European Patent Office
Office européen des brevets

(11) **EP 4 340 030 A1**

(12) **EUROPEAN PATENT APPLICATION**
published in accordance with Art. 153(4) EPC

(43) Date of publication:
**20.03.2024 Bulletin 2024/12**

(21) Application number: **22823933.1**

(22) Date of filing: **05.05.2022**

(51) International Patent Classification (IPC):
*H01L 27/32* (2006.01)    *H01L 51/52* (2006.01)
*H01L 51/56* (2006.01)

(52) Cooperative Patent Classification (CPC):
**H10K 50/80; H10K 59/00; H10K 71/00**

(86) International application number:
**PCT/CN2022/090940**

(87) International publication number:
**WO 2022/262450 (22.12.2022 Gazette 2022/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.06.2021 CN 202110665834**

(71) Applicant: **Huawei Technologies Co., Ltd.
Longgang
Shenzhen, Guangdong 518129 (CN)**

(72) Inventors:
• **LONG, Haohui
Shenzhen, Guangdong 518129 (CN)**

• **ZHAO, Yingbo
Shenzhen, Guangdong 518129 (CN)**
• **LI, Xiaolong
Shenzhen, Guangdong 518129 (CN)**
• **HUANG, Limei
Shenzhen, Guangdong 518129 (CN)**
• **LI, Jianhui
Shenzhen, Guangdong 518129 (CN)**
• **XIAO, Tian
Shenzhen, Guangdong 518129 (CN)**
• **FANG, Jianping
Shenzhen, Guangdong 518129 (CN)**
• **ZHANG, Shi
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **DISPLAY DEVICE AND MANUFACTURING METHOD THEREFOR**

(57) Embodiments of this application provide a display apparatus and a method for manufacturing the display apparatus, and relate to the field of display technologies, so that a cover has good impact resistance performance, scratch resistance performance, and bending performance, to effectively improve reliability of the display apparatus. The display apparatus includes: an array substrate, where the array substrate includes a substrate and an array layer located on a side of the substrate; and a cover, where the cover is located on a side that is of the array layer and that is opposite to the substrate, the cover includes a first film layer and a second film layer, and the first film layer is located on a side that is of the second film layer and that is opposite to the substrate, where the first film layer is formed by a high modulus material, an elastic modulus of the high modulus material is E1, 50 Mpa≤E1≤5 Gpa, and the second film layer is formed by a modified energy absorption impact resistance material that has viscosity and shear thickening behavior.

FIG. 4

EP 4 340 030 A1

## Description

This application claims priority to Chinese Patent Application No. 202110665834.4, filed with the China National Intellectual Property Administration on June 16, 2021 and entitled "DISPLAY APPARATUS AND MANUFACTURING METHOD THEREOF", which is incorporated herein by reference in its entirety.

## TECHNICAL FIELD

The present invention relates to the field of display technologies, and more specifically, to a display apparatus and a method for manufacturing the display apparatus.

## BACKGROUND

With increasingly mature flexible foldable screen technologies, foldable display apparatuses are a major trend in the future development of mobile terminals. After being folded, the display apparatus looks similar to a size of a conventional mobile phone, and is more portable. After being unfolded, a display of the display apparatus may be about twice a screen of the conventional mobile phone, to bring brand new visual experience and convenience to a user in fields such as reading, gaming, and office.

A cover of a conventional non-foldable display apparatus is a glass cover, and the glass cover can well resist impact of external force, and effectively protect a display from being cracked. However, a cover of the foldable display apparatus is formed by a flexible material. When a display of the display apparatus is subjected to force such as extrusion or collision, it is difficult for the cover to effectively protect the display. Consequently, reliability of the foldable display apparatus in aspects such as extrusion, ball falling, and falling is poor.

## SUMMARY

In view of this, this application provides a display apparatus and a method for manufacturing the display apparatus, so that a cover has good impact resistance performance, scratch resistance performance, and bending performance, to effectively improve reliability of the display apparatus.

According to a first aspect, an embodiment of this application provides a display apparatus, including:

an array substrate, where the array substrate includes a substrate and an array layer located on a side of the substrate; and

a cover, where the cover is located on a side that is of the array layer and that is opposite to the substrate, the cover includes a first film layer and a second film layer, and the first film layer is located on a side that is of the second film layer and that is opposite to the substrate, where

the first film layer is formed by a high modulus material, an elastic modulus of the high modulus material is E1, 50 Mpa≤E1≤5 Gpa, and the second film layer is formed by a modified energy absorption impact resistance material that has viscosity and shear thickening behavior.

In an implementation, the modified energy absorption impact resistance material includes modified silicone rubber, modified thermoplastic polyurethane, modified polyurethane, or a modified shear thickening material.

In an implementation, a molecular structure of the modified energy absorption impact resistance material includes a bonded polymer molecular main chain and a modified polymer molecular main chain, where the modified polymer molecular main chain has a hydrogen bond or a coordination bond, and the coordination bond includes a boron-oxygen bond, a metal-catechol, or a metal-histidine.

Further, an elastic modulus of the second film layer is E2, and 10 Kpa≤E2≤500 Mpa.

Further, a film thickness of the first film layer is less than a film thickness of the second film layer in a direction perpendicular to a plane on which the substrate is located.

In an implementation, the cover further includes a third film layer, the third film layer is located on a side that is of the second film layer and that faces the substrate, the third film layer is formed by a high modulus material, an elastic modulus formed by the high modulus material is E3, and 50 Mpa≤E3≤5 Gpa.

In an implementation, the cover further includes a fourth film layer, the fourth film layer is located on a side that is of the second film layer and that faces the substrate, and the fourth film layer is formed by a modified energy absorption impact resistance material that has viscosity and shear thickening behavior.

In an implementation, the array layer includes inorganic insulation layers, at least one layer of the inorganic insulation layers has a hollow part, and the hollow part is filled with an organic part.

Further, the array layer includes a protective layer, a semiconductor layer, a first gate insulation layer, a first gate layer, a second gate insulation layer, a second gate layer, an interlayer insulation layer, and a source/drain layer that are disposed opposite to the substrate in a laminated manner, and the inorganic insulation layer includes the protective layer, the first gate insulation layer, the second gate insulation layer, and the interlayer insulation layer, where

the protective layer has a first hollow part, and the first hollow part does not overlap the semiconductor layer in a direction perpendicular to a plane on which the substrate is located;

the first gate insulation layer has a second hollow part, and the second hollow part does not overlap the first gate layer in the direction perpendicular to the plane on which the substrate is located;

the second gate insulation layer has a third hollow part, and the third hollow part does not overlap the second gate layer in the direction perpendicular to the plane on which the substrate is located; and

the interlayer insulation layer has a fourth hollow part, the display apparatus includes a display area, and the fourth hollow part covers the display area in the direction perpendicular to the plane on which the substrate is located.

Further, the display apparatus includes a display area and a non-display area, the non-display area includes a shift register circuit area and a fan-shaped cabling area, the hollow part is located in the display area and the shift register circuit area, and the hollow part does not overlap the fan-shaped cabling area in a direction perpendicular to a plane on which the substrate is located.

In an implementation, the display apparatus further includes a protective film, where the protective film is located on a side that is of the cover and that is opposite to the substrate; and

the protective film includes an anti-reflection layer, the anti-reflection layer includes a hollow anti-reflection particle, a particle size of the anti-reflection particle is r, and 25 nm$\leq$r$\leq$30 nm; and/or a particle wall thickness of the anti-reflection particle is k, and 10 nm$\leq$k$\leq$12 nm.

In an implementation, the protective film further includes a hard coating, and the hard coating is located between the anti-reflection layer and the cover, where

a hardness of the hard coating is h, and 1 H$\leq$h$\leq$2 H; and/or in a direction perpendicular to a plane on which the substrate is located, a film thickness of the hard coating is D1, and 5 $\mu$m$\leq$D1$\leq$8 $\mu$m; and/or an elastic modulus of the hard coating is E4, and 80 Gpa$\leq$E4$\leq$100 Gpa.

In an implementation, the display apparatus further includes an adhesive layer, the adhesive layer is located between the cover and the array layer, a glass transition temperature of the adhesive layer is Tg, and Tg$\leq$-40°C.

Further, an adhesive layer solution forming the adhesive layer is synthesized by materials with the following mass percentages: a first soft monomer 40% to 66%, a second soft monomer 2% to 8%, an initiator 0.05% to 0.4%, a cross-linking agent 0.05% to 0.5%, a hard monomer 2% to 10%, and a macromolecular polymer 30% to 50%, where glass transition temperatures of the first soft monomer and the second soft monomer are less than or equal to -40°C, and a glass transition temperature of the hard monomer is greater than or equal to 0°C.

Further, the first soft monomer and the second soft monomer separately include one or more of isooctyl acrylate, n-hexyl acrylate, hydroxybutyl acrylate, and n-butyl acrylate;

the hard monomer includes at least one of a hydroxyl acrylate monomer, a carboxy acrylate monomer, an amino-acrylate monomer, and a dicyclopentanyl acrylate;

the initiator includes a free radical photoinitiator;

the cross-linking agent includes a bifunctional acrylate active polymer, and a molecular weight of the cross-linking agent is greater than or equal to 200 g/mol and less than or equal to 5000 g/mol; and

the macromolecular polymer is prepared by prepolymerizing the first soft monomer, the second soft monomer, and the hard monomer, and a molecular weight of the macromolecular polymer is greater than or equal to $10\times10^4$ g/mol and less than or equal to $100\times10^4$ g/mol.

In an implementation, in a direction perpendicular to a plane on which the substrate is located, a film thickness of the adhesive layer is D2, and 15 $\mu$m$\leq$D2$\leq$100 $\mu$m; and/or an elastic modulus of the adhesive layer is E5, and 5 Kpa$\leq$E5$\leq$50 Mpa.

Based on a same inventive concept, an embodiment of this application further provides a method for manufacturing a display apparatus, including:

forming an array layer on a substrate; and

forming a cover, where a process of forming the cover includes: forming a second film layer on a side that is of the array layer and that is opposite to the substrate, where the second film layer is formed by a modified energy absorption impact resistance material that has viscosity and shear thickening behavior; and forming a first film layer on a side that is of the second film layer and that is opposite to the substrate, where the first film layer is formed by a high modulus material, an elastic modulus formed by the high modulus material is E1, and 50 Mpa$\leq$E1$\leq$5 Gpa.

In an implementation, before the second film layer is formed, the process of forming the cover further includes: forming a third film layer on the side that is of the array layer and that is opposite to the substrate, where the third film layer is formed by a high modulus material, an elastic modulus formed by the high modulus material is E3, and 50 Mpa≤E3≤5 Gpa.

In an implementation, before the second film layer is formed, the process of forming the cover further includes: forming a fourth film layer on the side that is of the array layer and that is opposite to the substrate, where the fourth film layer is formed by a modified energy absorption impact resistance material that has viscosity and shear thickening behavior.

In an implementation, a process of forming the array layer includes: forming inorganic insulation layers, forming a hollow part in at least one layer of the inorganic insulation layers, and filling the hollow part with an organic material to form an organic part.

Further, the process of forming the array layer includes:

sequentially forming a protective layer, a semiconductor layer, a first gate insulation layer, a first gate layer, a second gate insulation layer, a second gate layer, and an interlayer insulation layer on the substrate, where the inorganic insulation layer includes the protective layer, the first gate insulation layer, the second gate insulation layer, and the interlayer insulation layer;

etching the interlayer insulation layer and the second gate insulation layer, to form a fourth hollow part on the interlayer insulation layer and a third hollow part on the second gate insulation layer, where in a direction perpendicular to a plane on which the substrate is located, the fourth hollow part covers a display area of the display apparatus, and the third hollow part does not overlap the second gate layer;

etching the first gate insulation layer and the protective layer, to form a second hollow part on the first gate insulation layer and a first hollow part on the protective layer, where the second hollow part and the first hollow part do not overlap the semiconductor layer and the first gate layer in the direction perpendicular to the plane on which the substrate is located;

filling the first hollow part, the second hollow part, the third hollow part, and the fourth hollow part with the organic material; and

forming a source/drain layer.

In an implementation, after the cover is formed, the manufacturing method further includes: forming a protective film including an anti-reflection layer, where

a process of forming the anti-reflection layer includes: forming a core microsphere/microemulsion through self-assembly or by using a surfactant, preparing a silicon dioxide shell layer on a surface of the core microsphere by using a sol-gel method, and then repeatedly cleaning and taking away the core microsphere by using solvent, to form hollow silicon dioxide, where a particle size of the hollow silicon dioxide is r, 25 nm≤r≤30nm, and/or a particle wall thickness of the hollow silicon dioxide is k, and 10 nm≤k≤12 nm.

In an implementation, before the anti-reflection layer is formed, a process of forming the protective film further includes: forming a hard coating, where a hardness of the hard coating is h, and 1 H≤h≤2 H; and/or in a direction perpendicular to a plane on which the substrate is located, a film thickness of the hard coating is d4, and 5 μm≤d4≤8 μm; and/or an elastic modulus of the hard coating is E4, and 80 Gpa≤E4≤100 Gpa.

In an implementation, before the second film layer is formed, the manufacturing method further includes: forming an adhesive layer; and

a process of forming the adhesive layer includes: configuring an adhesive layer solution and preparing the adhesive layer by using the configured adhesive layer solution, where the adhesive layer solution is synthesized by materials with the following mass percentages: a first soft monomer 40% to 66%, a second soft monomer 2% to 8%, an initiator 0.05% to 0.4%, a cross-linking agent 0.05% to 0.5%, a hard monomer 2% to 10%, and a macromolecular polymer 30% to 50%, and glass transition temperatures of the first soft monomer and the second soft monomer are less than or equal to -40°C, and a glass transition temperature of the hard monomer is greater than or equal to 0°C.

The display apparatus and the method for manufacturing the display apparatus provided in this application have the following beneficial effects:

In this embodiment of the present invention, the cover of the display apparatus is a laminated structure formed by laminating at least the first film layer and the second film layer. In embodiments of the present invention, the first film layer and the second film layer are designed to have different characteristics, and the first film layer and the second film layer can cooperate with each other in terms of performance, so that the cover has good impact resistance performance, scratch resistance performance, and bending performance. This improves a protection capability for the display apparatus.

Specifically, the first film layer has a high elastic modulus and a corresponding high hardness. The first film layer is disposed on an outer side of the display apparatus. When the display apparatus is impacted or extruded by external force, an impact stress or an extrusion stress first acts on the first film layer. In this case, the first film layer with high hardness can improve the scratch resistance performance, prevent a screen of the display apparatus from being scratched, and effectively reduce a deformation under the impact stress or the extrusion stress. This effectively reduces strain of a film layer, such as an inorganic layer, inside the display apparatus. Further, another second film layer that absorbs energy and resists impact and that has the viscosity and the shear thickening behavior is disposed on an inner side of the first film layer, so that buffering effect can be further implemented by using the second film layer. The second film layer may convert mechanical energy generated by impact or extrusion into heat energy, and absorb the impact energy or the extrusion energy. In addition, the second film layer has the shear thickening behavior. At a low stress rate, the second film layer keeps a material soft, and has better bending performance. At a high stress rate, an elastic modulus of the second film layer increases, effectively blocking an external impact stress or extrusion stress, and protecting the display apparatus from damage. In addition, the second film layer has viscosity, to improve adhesion between the second film layer and two adjacent film layers. When the display apparatus is bent or is subjected to external force, a risk of detaching the second film layer can be reduced. This improves reliability of the second film layer in energy absorption and impact resistance.

## BRIEF DESCRIPTION OF DRAWINGS

FIG. 1 is a schematic diagram of a structure of a display apparatus in the conventional technology;

FIG. 2 is a schematic diagram of another structure of a display apparatus in the conventional technology;

FIG. 3 is a schematic diagram of a structure of a light emitting device layer in the conventional technology;

FIG. 4 is a schematic diagram of a structure of a display apparatus according to an embodiment of the present invention;

FIG. 5 is a schematic diagram of a molecular structure of a modified energy absorption impact resistance material according to an embodiment of the present invention;

FIG. 6A is a schematic diagram of another structure of a display apparatus according to an embodiment of the present invention;

FIG. 6B is a schematic diagram of still another structure of a display apparatus according to an embodiment of the present invention;

FIG. 7 is a schematic diagram of cracking of an inorganic insulation layer in the conventional technology;

FIG. 8 is an enlarged schematic diagram of an area A in FIG. 7;

FIG. 9 is a schematic diagram of a bending direction of a display apparatus in the conventional technology;

FIG. 10 is a schematic diagram of bending of a display apparatus in the conventional technology;

FIG. 11 is a schematic diagram in which a front side of a display apparatus is extruded in the conventional technology;

FIG. 12 is a schematic diagram of still another structure of a display apparatus according to an embodiment of the present invention;

FIG. 13 is a schematic diagram of still another structure of a display apparatus according to an embodiment of the present invention;

FIG. 14 is a schematic diagram of a bending working condition according to an embodiment of the present invention;

FIG. 15 is a schematic diagram of an extrusion working condition according to an embodiment of the present invention;

FIG. 16 is a top view of a display apparatus according to an embodiment of the present invention;

FIG. 17 is a sectional view of FIG. 16 along a direction of A1-A2;

FIG. 18 is a schematic diagram of a structure of a protective film according to an embodiment of the present invention;

FIG. 19 is a schematic diagram in which a protective film is scraped according to an embodiment of the present invention;

FIG. 20 is a schematic diagram of deformation of a protective film according to an embodiment of the present invention;

FIG. 21 is a schematic diagram of a structural comparison of two anti-reflection layers according to an embodiment of the present invention;

FIG. 22 is a simulation curve diagram of acting force and simulation time according to an embodiment of the present invention;

FIG. 23 is a schematic diagram of still another structure of a display apparatus according to an embodiment of the present invention;

FIG. 24 is a flowchart of a manufacturing method according to an embodiment of the present invention;

FIG. 25 is a flowchart of a structure of a method for manufacturing an array layer according to an embodiment of the present invention;

FIG. 26A is a schematic diagram of a molecular structure of a sulfonium salt according to an embodiment of the present invention;

FIG. 26B is a schematic diagram of a molecular structure of ladder-like siloxane according to an embodiment of the present invention; and

FIG. 26C is a schematic diagram of a molecular structure of cage-like siloxane according to an embodiment of the present invention.

## DESCRIPTION OF EMBODIMENTS

To make the objectives, technical solutions, and advantages of embodiments of the present invention clearer, the following clearly and completely describes the technical solutions in embodiments of the present invention with reference to the accompanying drawings in embodiments of the present invention. It is clear that the described embodiments are some but not all of embodiments of the present invention. All other embodiments obtained by a person skilled in the art based on embodiments of the present invention without creative efforts shall fall within the protection scope of the present invention.

Terms used in embodiments of the present invention are merely for the purpose of illustrating specific embodiments, and are not intended to limit the present invention. The terms "a", "said", and "the" of singular forms used in embodiments and the appended claims of the present invention are also intended to include plural forms, unless otherwise specified in the context clearly.

Before the technical solutions provided in the present invention are described, the present invention first describes a structure of a display apparatus in detail, so as to have a deeper understanding of the display apparatus.

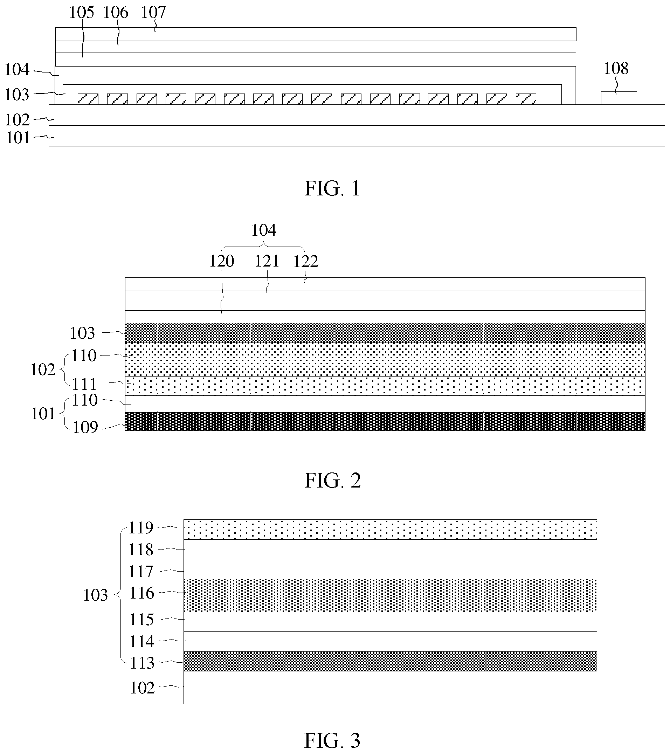

FIG. 1 is a schematic diagram of a structure of a display apparatus in the conventional technology. As shown in FIG. 1, the display apparatus includes a substrate 101, an array substrate 102, a light emitting device layer 103, a packaging layer 104, a polarizer 105, a touch layer 106, and a cover 107 that are disposed in a laminated manner. In addition, the display apparatus further includes a driver chip 108 bound to the array substrate 102.

FIG. 2 is a schematic diagram of another structure of the display apparatus in the conventional technology. As shown in FIG. 2, the substrate 101 may specifically include a steel sheet 109, and a transition layer 110 such as a bottom film and an adhesive. The array substrate 102 may specifically include a substrate 111 formed by a polyimide (Polyimide, PI) material, and an array layer 112 located on a side of the substrate 111. The array layer 112 may specifically include a semiconductor layer and a metal layer that are used to form an electronic device (such as a transistor and a storage capacitor), and a plurality of inorganic insulation layers. FIG. 3 is a schematic diagram of a structure of the light emitting device layer in the conventional technology. As shown in FIG. 3, the light emitting device layer 103 may specifically include an anode 113, a hole injection layer 114, a hole transport layer 115, a light emitting layer 116, an electron transport layer 117, an electron injection layer 118, and a cathode 119 that are disposed in a laminated manner. When the display apparatus is driven to emit light, an electronic device in the array layer 112 transmits a drive current to the anode 113, and an electron and a hole are separately injected into the light emitting layer 116 for recombination luminescence. Referring to FIG. 2 again, the packaging layer 104 may specifically include a first inorganic packaging layer 120, an organic packaging layer 121, and a second inorganic packaging layer 122 that are disposed in a laminated manner. The packaging layer 104 is configured to prevent external oxygen from penetrating, and protect the light emitting device and the electronic device in the display apparatus.

In the conventional technology, the cover 107 in the foldable display apparatus is generally a single-layer film structure formed by a material such as polyethylene glycol terephthalate (Polyethylene glycol terephthalate, PET), thermoplastic polyurethane (Thermoplastic polyurethane, TPU), or clear polyimide (Clear Polyimide, CPI). Because the type of the forming material of the cover 107 is single, a characteristic of the cover 107 is also single. For example, when the cover 107 is a PET thin film, the PET thin film is made of a hard material and has poor impact resistance performance. After a screen of the display apparatus is impacted by external force, it is difficult to absorb or dissipate impact energy. When the cover 107 is a TPU thin film, the TPU thin film is made of a rubber material. Although the material is soft and can absorb specific impact energy, a surface has poor scratch resistance and scratch resistance capabilities, and is not resistant to extrusion.

Therefore, it is difficult for the cover 107 in the existing display apparatus to have good impact resistance performance, scratch resistance performance, and bending performance at the same time, and consequently, reliability of the display apparatus is poor.

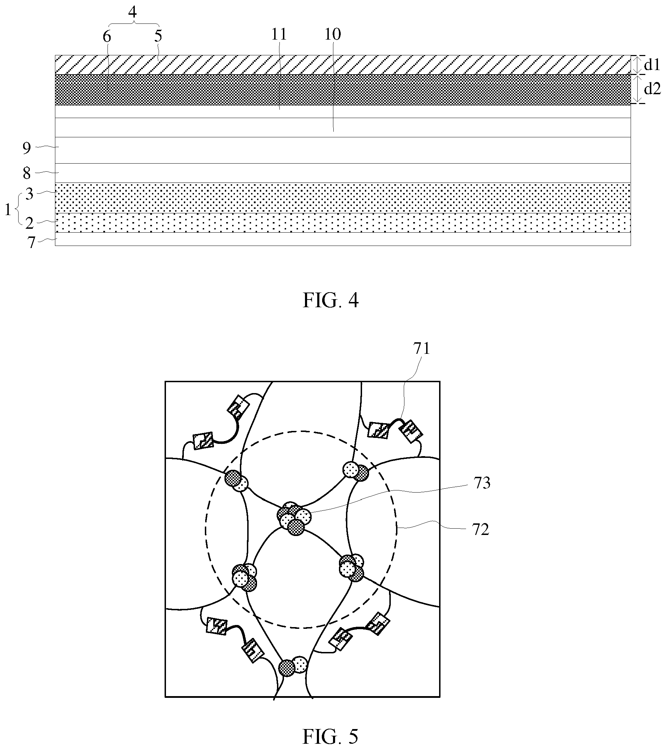

Therefore, an embodiment of the present invention provides a display apparatus. FIG. 4 is a schematic diagram of a structure of a display apparatus according to an embodiment of the present invention. As shown in FIG. 4, the display apparatus includes an array substrate 1, and the array substrate 1 includes a substrate 2 and an array layer 3 located on a side of the substrate 2. The display apparatus further includes a cover 4. The cover 4 is located on a side that is of the array layer 3 and that is opposite to the substrate 2, the cover 4 includes a first film layer 5 and a second film layer 6, and the first film layer 5 is located on a side that is of the second film layer 6 and that is opposite to the substrate 2.

The first film layer 5 is formed by a high modulus material, an elastic modulus of the high modulus material is E1, and 50 Mpa≤E1≤5 Gpa. For example, the first film layer 5 may be formed by an organic material such as TPU, polyurethane (polyurethane, PU) or polycarbonate (Polycarbonate, PC), PET, PI, or polymethyl methacrylate (Polymethyl Methacrylate, PMMA). The second film layer 6 is formed by a modified energy absorption impact resistance material that has viscosity and shear thickening behavior.

It should be noted that, referring to FIG. 4 again, the display apparatus further includes a substrate 7, a light emitting device layer 8, a packaging layer 9, a polarizer 10, and a touch layer 11. A specific film layer structure of this part of structure and a relative position relationship between this part of structure and the array substrate 1 and the cover 4 are the same as those in the conventional technology, and details are not described herein again.

In this embodiment of the present invention, the cover 4 in the display apparatus is a laminated structure formed by laminating at least the first film layer 5 and the second film layer 6. In embodiments of the present invention, the first film layer 5 and the second film layer 6 are designed to have different characteristics, and the first film layer 5 and the second film layer 6 can cooperate with each other in terms of performance, so that the cover 4 has good impact resistance performance, scratch resistance performance, and bending performance. This improves a protection capability for the display apparatus.

Specifically, the first film layer 5 has a high elastic modulus and a correspondingly high hardness. The first film layer is disposed on an outer side of the display apparatus. When the display apparatus is impacted or extruded by external force, an impact stress or an extrusion stress first acts on the first film layer 5. In this case, the first film layer 5 with high hardness can improve the scratch resistance performance, prevent a screen of the display apparatus from being scratched, and effectively reduce a deformation under the impact stress or the extrusion stress. This effectively reduces strain of a film layer, such as an inorganic layer, inside the display apparatus. Further, another second film layer 6 that absorbs energy and resists impact and that has the viscosity and the shear thickening behavior is disposed on an inner side of the first film layer 5, so that a buffering effect can be further implemented by using the second film layer 6. The second film layer 6 may convert mechanical energy generated by impact or extrusion into heat energy, and absorb the impact energy or the extrusion energy. In addition, the second film layer 6 has the shear thickening behavior. At a low stress rate, the second film layer 6 keeps a material soft, and has better bending performance. At a high stress rate, an elastic modulus of the second film layer 6 increases, effectively blocking an external impact stress or extrusion stress, and protecting the display apparatus from damage. In addition, the second film layer 6 has the viscosity, to improve adhesion between the second film layer 6 and two adjacent film layers. When the display apparatus is bent or is subjected to external force, a risk of detaching the second film layer 6 can be reduced. This improves reliability of the second film layer 6 in energy absorption and impact resistance.

It is verified that, compared with a PET single-layer thin film or a TPU single-layer thin film of a same thickness, impact resistance performance of the cover 4 of the laminated structure provided in this embodiment of the present invention can be improved by at least 100%.

In an implementation, the modified energy absorption impact resistance material used to form the second film layer 6 may specifically include modified silicone rubber, modified thermoplastic polyurethane (Thermoplastic polyurethane, TPU), modified polyurethane (polyurethane, PU), or a modified shear thickening material. This kind of material is softer and more deformed, so the energy absorption effect is better. Further, the modified energy absorption impact resistance material may be specifically polyborosiloxane modified silicone rubber.

In an implementation, FIG. 5 is a schematic diagram of a molecular structure of a modified energy absorption impact resistance material according to an embodiment of the present invention. As shown in FIG. 5, the molecular structure of the modified energy absorption impact resistance material includes a bonded polymer molecular main chain 71 and a modified polymer molecular main chain 72, where the modified polymer molecular main chain 72 has a hydrogen bond or a coordination bond, and the coordination bond includes a boron-oxygen bond, a metal-catechol, or a metal-histidine. The hydrogen bond or the coordination bond in FIG. 5 is represented by reference sign 73.

The polymer molecular main chain is a silicone rubber molecular main chain, and the modified polymer molecular main chain is a modified silicone rubber molecular main chain; or the polymer molecular main chain is a TPU molecular main chain, and the modified polymer molecular main chain is a modified TPU molecular main chain; or the polymer molecular main chain is a PU molecular main chain, and the modified polymer molecular main chain is a modified PU molecular main chain.

In this embodiment of the present invention, a molecular structure of a material formed by the second film layer 6 is adjusted at a microscopic level, and the coordination bond such as the hydrogen bond or the boron-oxygen bond, the boron-oxygen bond, the metal-catechol, or the metal-histidine is introduced into the molecular structure, so that the material has the shear thickening behavior. A polymer molecule main chain is bonded with the modified polymer molecular main chain, and the material may have the viscosity by using the modified polymer molecular main chain. Therefore, the finally formed second film layer 6 has both the viscosity and the shear thickening behavior, and performance of the second film layer 6 is optimized.

In an implementation, an elastic modulus of the second film layer 6 is E2, and 10 Kpa≤E2≤500 Mpa. For the second film layer 6, to achieve good energy absorption effect, the second film layer 6 needs to have sufficient deformation to absorb energy. Therefore, the elastic modulus of the second film layer 6 should not be excessively high. However, if the elastic modulus of the second film layer 6 is excessively low, a material of the second film layer 6 is excessively soft, and the second film layer 6 generates a great deformation under an impact stress or an extrusion stress. Because the second film layer 6 has specific viscosity, the second film layer 6 and an adjacent side film layer are pulled from each other, and a risk of detaching the second film layer 6 is increased. Therefore, in this embodiment of the present invention, the elastic modulus of the second film layer 6 is set in a range of 10 Kpa to 500 Mpa, so that an excessively low elastic modulus can be avoided, good energy absorption effect of the second film layer 6 can be ensured, and an excessively high elastic modulus can be avoided. This reduces a risk of detaching the second film layer 6 under external force.

It should be noted that, when the display apparatus is impacted or extruded, stress mainly acts on each film layer as transverse shear force and longitudinal extrusion force. When the stress acts on the first film layer 5, the shear force horizontally spreads to surroundings with vibration of the first film layer 5, and the extrusion force continues to longitudinally spread to the second film layer 6. The extrusion force is absorbed to a specific extent by using the second film layer 6. To ensure that the first film layer 5 and the second film layer 6 have sufficient thicknesses to optimize vibration energy dissipation effect or energy absorption effect of the first film layer 5 and the second film layer 6, and reduce impact of the stress on another film layer, referring to FIG. 4 again, in a direction perpendicular to a plane on which the substrate 2 is located, a film thickness of the first film layer 5 is d1, where 20 $\mu$m≤d1≤200 $\mu$m; and a film thickness of the second film layer 6 is d2, where 20 $\mu$m≤d2≤200 $\mu$m.

Further, in the direction perpendicular to the plane on which the substrate 2 is located, the film thickness of the first film layer 5 is less than the film thickness of the second film layer 6. For example, the film thickness of the first film layer 5 is 50 $\mu$m, and the film thickness of the second film layer 6 is 100 $\mu$m. The second film layer 6 is disposed thicker, so that deformation of the second film layer 6 in a thickness direction can be increased, to further improve the energy absorption impact resistance effect of the second film layer 6.

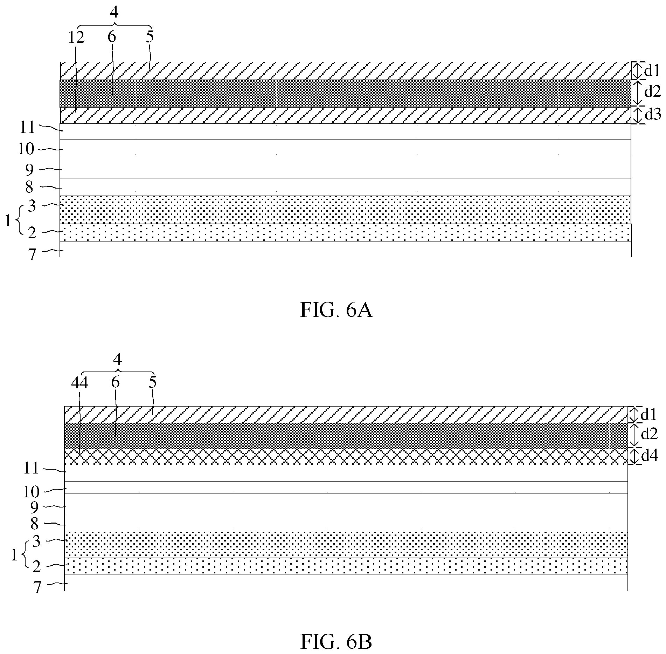

In an implementation, FIG. 6A is a schematic diagram of another structure of the display apparatus according to an embodiment of the present invention. As shown in FIG. 6A, the cover 4 further includes a third film layer 12, the third film layer 12 is located on a side that is of the second film layer 6 and that faces the substrate 2, the third film layer 12 is formed by a high modulus material, and an elastic modulus formed by the high modulus material is E3, where 50 Mpa≤E3≤5 Gpa. For example, the third film layer 12 may be made of an organic material such as the TPU, the PU, the PC, the PET, the PMMA, or the PI.

The third film layer 12 with a high modulus is further added to the second film layer 6, and a hardness of the third film layer 12 is correspondingly high, so that large deformation generated by the second film layer 6 can be blocked, to avoid that deformation continues to accumulate to an inner side, and consequently relatively large deformation is also generated on a film layer in the array layer 3, so that the cover 4 has better impact resistance performance.

Further, to optimize impact resistance effect of the third film layer 12, referring to FIG. 6A again, in the direction perpendicular to the plane on which the substrate 2 is located, a film thickness of the third film layer 12 is d3, where 20 $\mu$m≤d3≤200 $\mu$m.

It should be noted that the third film layer 12 and the first film layer 5 may use a same material and a same film thickness, or may use different materials and different film thicknesses. For example, the first film layer 5 is formed by the PI material, and the film thickness is 50 $\mu$m. The second film layer 6 is formed by the polyborosiloxane modified silicone rubber, and the film thickness is 100 $\mu$m. The third film layer 12 is formed by the PET material, and the film thickness is 50 $\mu$m.

In an implementation, FIG. 6B is a schematic diagram of still another structure of the display apparatus according to an embodiment of the present invention. As shown in FIG. 6B, the cover 4 further includes a fourth film layer 44, the fourth film layer 44 is located on a side that is of the second film layer 6 and that faces the substrate 2, and the fourth film layer 44 is formed by a modified energy absorption impact resistance material that has the viscosity and the shear thickening behavior.

The fourth film layer 44 formed by the modified energy absorption impact resistance material is further disposed on an inner side of the second film layer 6, so that impact energy or extrusion energy can be further absorbed by using the fourth film layer 44, to achieve better buffering effect, and the cover 4 can have better extrusion resistance performance by using the viscosity and the shear thickening behavior of the fourth film layer 44.

Further, referring to FIG. 6B again, in the direction perpendicular to the plane on which the substrate 2 is located, a film thickness of the fourth film layer 44 is d4, where 20 $\mu$m≤d4≤200 $\mu$m.

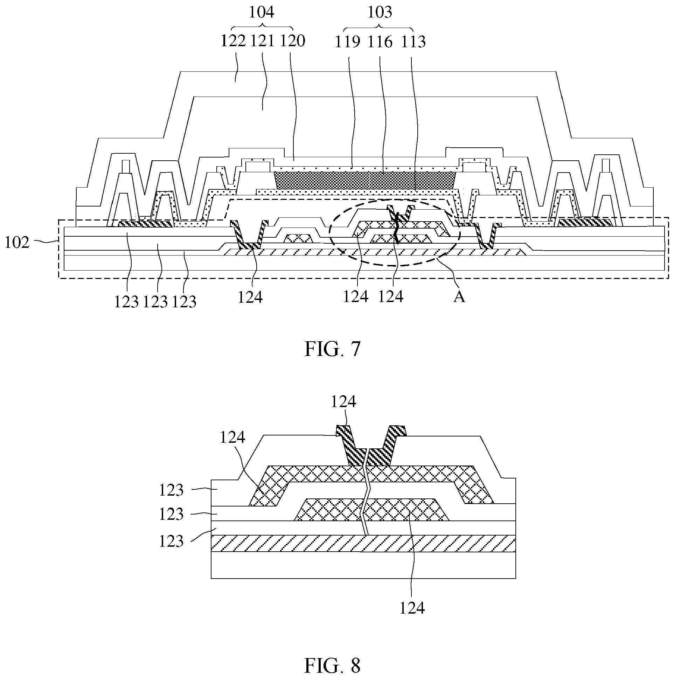

In addition, it should be further noted that a film layer structure of the display apparatus includes a plurality of inorganic layers. For example, the array substrate includes a plurality of inorganic insulation layers, and the packaging layer includes a plurality of inorganic packaging layers. Compared with an organic material, the inorganic material has poor bending resistance. Consequently, it is difficult to release stress on a film layer inside the display apparatus. The inorganic insulation layers in the array substrate are used as an example. With reference to FIG. 1 and FIG. 2, FIG. 7 is a schematic diagram of cracking of an inorganic insulation layer in the conventional technology, and FIG. 8 is an enlarged schematic diagram of an area A in FIG. 7. As shown in FIG. 7 and FIG. 8, the array substrate 102 includes a plurality of inorganic insulation layers 123 and a plurality of metal layers 124. When the display apparatus is bent or subjected to external force, the inorganic insulation layer 123 cracks when the stress accumulates and exceeds the crack threshold of the inorganic insulation layer 123, and consequently, it is difficult to ensure impact resistance and bending reliability of the display apparatus. In addition, the cracking of the inorganic insulation layer 123 further causes a broken line of a metal layer 124 adjacent to an inorganic insulation layer 123, and consequently causes a bad display phenomenon such as a broken bright spot and a bright line on the display apparatus.

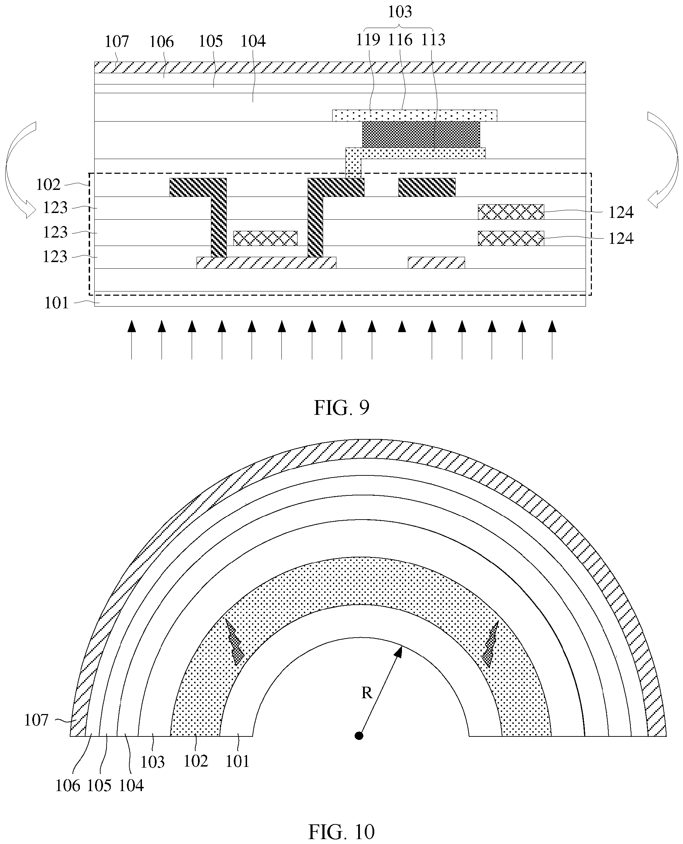

Particularly, for a bent display apparatus, with reference to FIG. 1 and FIG. 2, FIG. 9 is a schematic diagram of a bending direction of the display apparatus in the conventional technology, and FIG. 10 is a schematic diagram of bending of the display apparatus in the conventional technology. As shown in FIG. 9 and FIG. 10, as a bending radius R becomes smaller, bending or extrusion stress on the array substrate 102 becomes larger, and a risk of generating a crack by the inorganic insulation layers 123 in the array substrate 102 is also higher. Especially, when the bending radius R is reduced to 3 mm or even 1 mm, the inorganic insulation layer 123 has a high risk of breaking, which imposes a specific constraint on further development of the bending radius R.

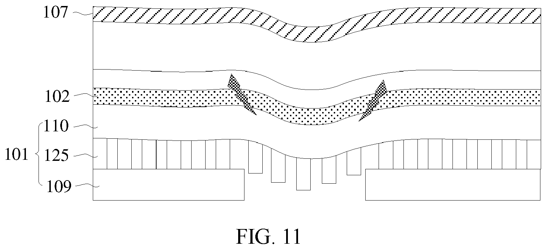

In addition, FIG. 11 is a schematic diagram in which a front surface of the display apparatus is extruded in the conventional technology. A bamboo book structure 125 shown in FIG. 11 is used to improve bending performance. As shown in FIG. 11, because the cover 107 on a surface of the existing display apparatus is a single-layer flexible thin film structure, when the front surface of the display apparatus is extruded, the cover 107 deforms greatly, and a corresponding array substrate 102 deforms greatly. As a result, a crack is more likely generated in the inorganic insulation layers 123 in the array substrate 102.

It can be learned that the inorganic insulation layers 123 in the existing display apparatus also have a large impact on reliability of the display apparatus.

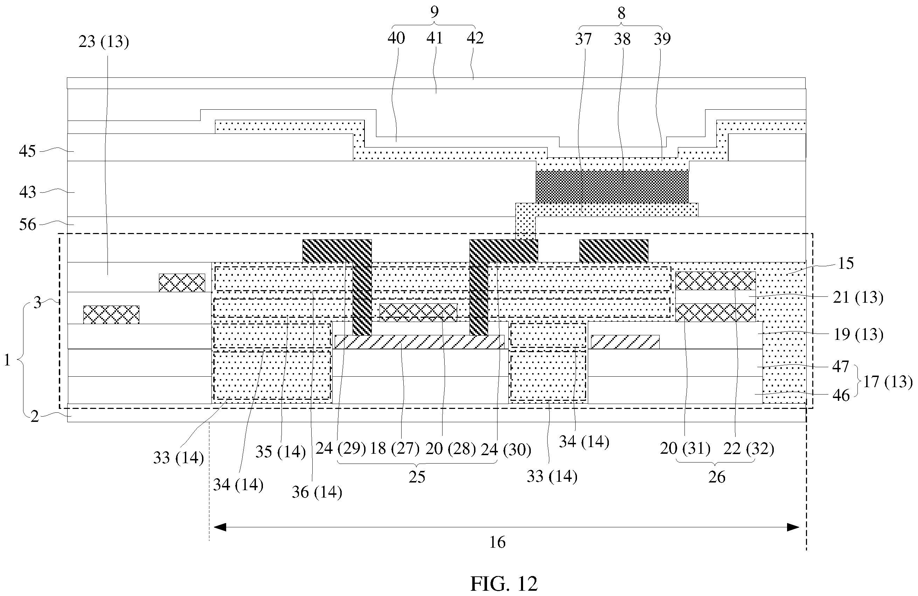

Therefore, in this embodiment of the present invention, FIG. 12 is a schematic diagram of still another structure of the display apparatus according to an embodiment of the present invention. As shown in FIG. 12, the array layer 3 includes inorganic insulation layers 13, at least one inorganic insulation layer 13 has a hollow part 14, and the hollow part 14 is filled with an organic part 15. Compared with the entire covering inorganic insulation layers 13, in this embodiment of the present invention, the hollow part 14 is disposed in the inorganic insulation layer 13, and the hollow part 14 is filled with an organic material, so that stress concentrated in the inorganic insulation layer 13 can be dispersed by using the organic material, to avoid stress accumulates to a crack threshold of the inorganic insulation layer 13, and effectively reduce a risk of breaking the inorganic insulation layer 13 and the metal layer in the array substrate 1. This improves the extrusion resistance performance and the bending performance of the display apparatus, but also avoids bad display phenomena such as broken bright spots and bright lines caused by broken wires of the metal layer.

Further, referring to FIG. 12 again, the display apparatus includes a display area 16. The array layer 3 includes a protective layer 17, a semiconductor layer 18, a first gate insulation layer 19, a first gate layer 20, a second gate insulation layer 21, a second gate layer 22, an interlayer insulation layer 23, and a source/drain layer 24 that are disposed opposite to the substrate 2 in a laminated manner, where the inorganic insulation layer 13 includes the protective layer 17, the first gate insulation layer 19, the second gate insulation layer 21, and the interlayer insulation layer 23. It should be noted that, the electronic device in the array layer 3 includes a transistor 25 and a storage capacitor 26. The transistor 25 includes an active layer 27 located at the semiconductor layer 18, a gate 28 located at the first gate layer 20, and a source 29 and a drain 30 located at the source/drain layer 24. The storage capacitor 26 includes a first electrode plate 31 located at the first gate layer 20 and a second electrode plate 32 located at the second gate layer 22.

The protective layer 17 has a first hollow part 33, the first hollow part 33 does not overlap the semiconductor layer 18 in a direction perpendicular to a plane on which the substrate 2 is located, the first gate insulation layer 19 has a second hollow part 34, the second hollow part 34 does not overlap the first gate layer 20 in the direction perpendicular to the plane on which the substrate 2 is located, the second gate insulation layer 21 has a third hollow part 35, the third hollow part 35 does not overlap the second gate layer 22 in the direction perpendicular to the plane on which the substrate 2 is located, the interlayer insulation layer 23 has a fourth hollow part 36, and the fourth hollow part 36 covers the display area 16 in the direction perpendicular to the plane on which the substrate 2 is located.

Based on the foregoing disposing manner, the protective layer 17, the first gate insulation layer 19, the second gate insulation layer 21, and the interlayer insulation layer 23 in the plurality of inorganic insulation layers 13 each have the hollow part 14, and the organic part 15 filled in the hollow part 14 is used to improve extrusion resistance performance and bending performance of the display apparatus to a greater extent. In addition, the hollow parts 14 of the protective layer 17, the first gate insulation layer 19, and the second gate insulation layer 21 do not overlap the metal layer or the semiconductor layer 18 on a side that is of the film layer and that is opposite to the substrate 2. In other words, a lower side of the metal layer or the semiconductor layer 18 is still adjacent to the inorganic material, so that the inorganic material can be used to achieve better insulation effect. For example, the inorganic material is still spaced between two electrode plates of the storage capacitor 26, and a capacitance medium layer of the storage capacitor 26 is still an inorganic layer. Because a dielectric constant of the inorganic material is high, an electronic characteristic of the storage capacitor 26 is better.

It should be noted that, referring to FIG. 12 again, a flattening layer 56 used to form a flat surface is disposed between the array layer 3 and the light emitting device layer 8. The light emitting device layer 8 includes an anode 37, a light emitting layer 38, and a cathode 39 that are disposed opposite to the substrate 2 in a laminated manner. The packaging layer 9 includes a first inorganic packaging layer 40, an organic packaging layer 41, and a second inorganic packaging layer 42 that are disposed opposite to the substrate 2 in a laminated manner. The display apparatus further includes a pixel definition layer 43 located on a side that is of the anode 37 and that is opposite to the substrate 2. The pixel definition layer 43 has an opening, and the light emitting layer 38 is located in the opening. In addition, the light emitting device layer 8 further includes a support column 45 located on a side that is of the pixel definition layer 43 and that is opposite to the substrate 2, and the support column 45 is configured to support a fine metal mask (Fine metal mask, FMM) during subsequent evaporation of the light emitting layer 38.

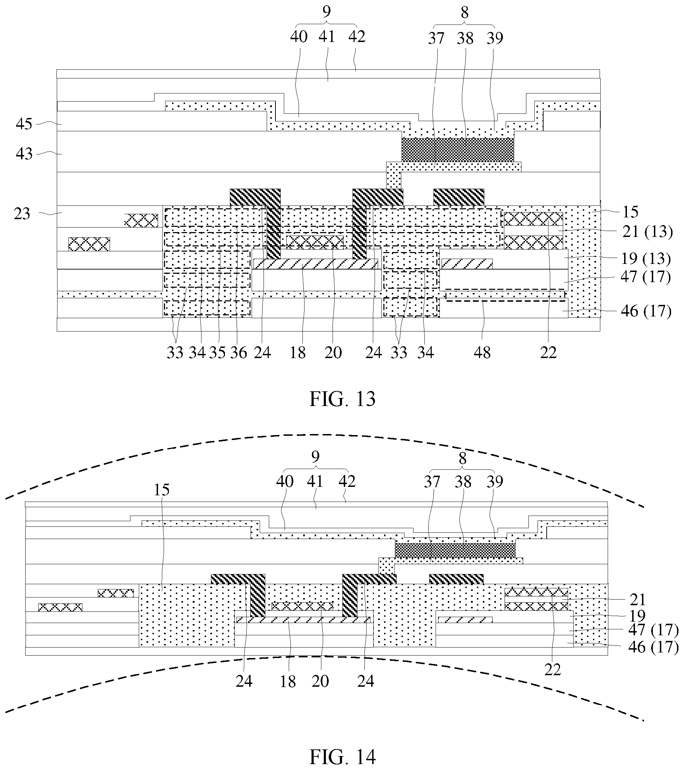

In addition, it should be further noted that, referring to FIG. 12 again, the protective layer 17 may specifically include an isolation layer 46 and a buffer layer 47 located on a side that is of the isolation layer 46 and that is opposite to the substrate 2. The isolation layer 46 and the buffer layer 47 can isolate Na+ and K+ in bearing glass. In addition, the buffer layer 47 may further play a thermal insulation role in an excimer laser annealing (Excimer laser annealing, ELA) process. FIG. 13 is a schematic diagram of still another structure of the display apparatus according to an embodiment of the present invention. As shown in FIG. 13, there may be another PI layer 48 between the isolation layer 46 and the buffer layer 47. When the isolation layer 46 and the buffer layer 47 are etched to form the hollow part 14, the buffer layer 47, the PI layer 48, and the isolation layer 46 may be patterned by using a same picture composition process. Then, hollow parts 14 of the buffer layer 47, the PI layer 48, and the isolation layer 46 are filled with an organic material to form the organic part 15.

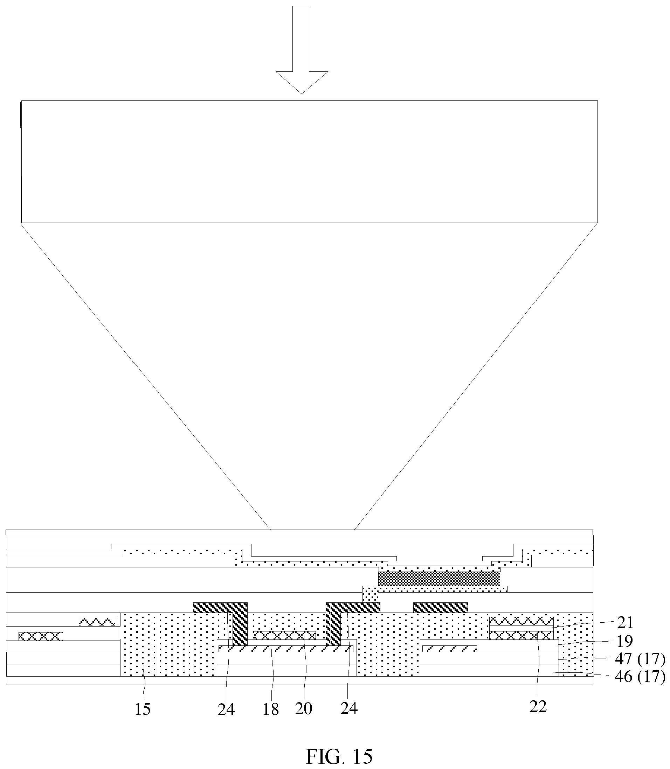

In addition, the inventors further verify the bending performance and the extrusion resistance performance of the foregoing structure. Compared with the existing structure shown in FIG. 7, when the structure provided in this embodiment of the present invention is used, FIG. 14 is a schematic diagram of a bending working condition according to an embodiment of the present invention. As shown in FIG. 14, when a display apparatus is bent to a specific bending state defined by a dashed line in the figure, a maximum main strain of an inorganic insulation layer, for example, the buffer layer 47, in the existing structure is 4858 ue. However, in the structure in this embodiment of the present invention, a maximum main strain of the buffer layer 47 is reduced to 4560 ue, and is reduced by 6.1%. FIG. 15 is a schematic diagram of an extrusion working condition according to an embodiment of the present invention. As shown in FIG. 15, when an extrusion head is used to extrude the display apparatus, the maximum main strain of the buffer layer 47 in the existing structure is 5754 ue. However, in the structure in this embodiment of the present invention, the maximum main strain of the buffer layer 47 is reduced to 5242 ue, and is reduced by 8.7%.

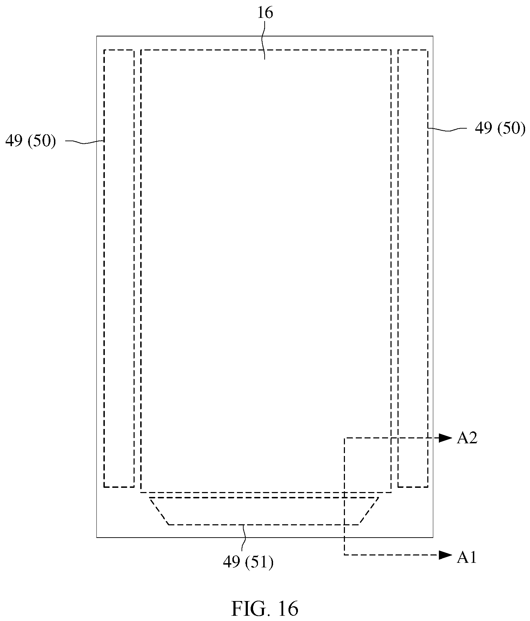

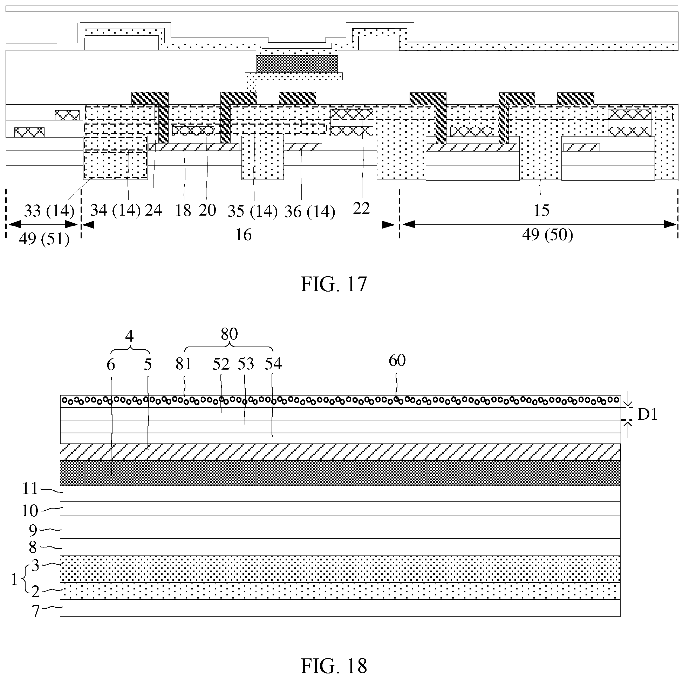

In an implementation, FIG. 16 is a top view of a display apparatus according to an embodiment of the present invention, and FIG. 17 is a sectional view of FIG. 16 along a direction of A1-A2. As shown in FIG. 16 and FIG. 17, the display apparatus includes a display area 16 and a non-display area 49, and the non-display area 49 includes a shift register circuit area 50 and a fan-shaped cabling area 51, a pixel circuit is disposed in the display area 16, and a shift register configured to output a scanning signal or a light emitting control signal to the pixel circuit is disposed in the shift register circuit area 50. A hollow part 14 is located in the display area 16 and the shift register circuit area 50. In a direction perpendicular to a plane on which the substrate 2 is located, the hollow part 14 does not overlap with the fan-shaped cabling area 51.

Usually, a cable in the fan-shaped cabling area 51 needs to transmit a high-current signal. By reserving an inorganic material in the fan-shaped cabling area 51, and patterning inorganic insulation layers 13 only for the display area 16 and the shift register circuit area 50, a metal cable in the fan-shaped cabling area 51 may still be adjacent to the inorganic material, to prevent high-current breakdown by using a characteristic of a good dielectric constant of the inorganic material.

In an implementation, FIG. 18 is a schematic diagram of a structure of a protective film according to an embodiment of the present invention. As shown in FIG. 18, the display apparatus further includes a protective film 80, and the protective film 80 is located on a side that is of the cover 4 and that is opposite to the substrate 2. The protective film 80 includes an anti-reflection layer 81, a hard coating 52 located on a side that is of the anti-reflection layer 81 and that faces the substrate 2, a PET layer 53 located on a side that is of the hard coating 52 and that faces the substrate 2, and an optical adhesive 54.

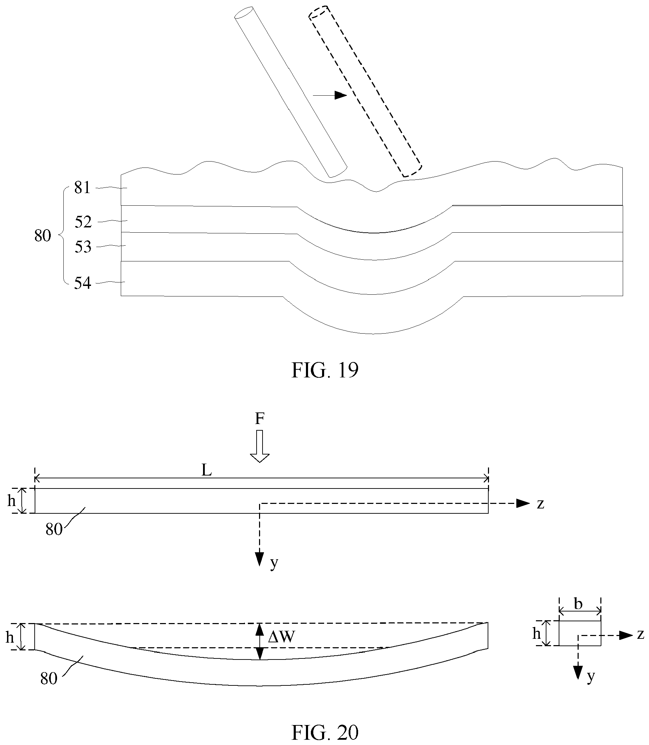

FIG. 19 is a schematic diagram in which a protective film is scraped according to an embodiment of the present invention, and FIG. 20 is a schematic diagram of deformation of a protective film according to an embodiment of the present invention. As shown in FIG. 19 and FIG. 20, when a protective film 80 is scratched, z-direction shear force and y-direction extrusion force are generated during the scraping. The shear force accumulates and scratches a surface of the protective film 80, and the extrusion force causes the protective film 80 to deform downward. When the protective film 80 deforms, a deflection increment of the protective film 80 is $\Delta W = \dfrac{FL^3}{4\mathrm{E}bh^3}$, where E is an elastic modulus of the protective film 80, F is force generated by scratch, L is a length of the protective film 80, h is a thickness of the protective film 80 in a direction perpendicular to the substrate 2, and B is a width of the protective film 80. It can be seen that the deflection increment of the protective film 80 is inversely proportional to the elastic modulus of the protective film 80. In other words, a harder protective film 80 indicates a smaller deflection increment of the protective film 80, and deformation degree of downward depression is smaller.

In an implementation, referring to FIG. 18 again, the anti-reflection layer 81 includes a hollow anti-reflection particle 60, where a particle size of the anti-reflection particle 60 is r, and 25 nm≤r≤30 nm; and/or a particle wall thickness of the anti-reflection particle 60 is k, and 10 nm≤k≤12 nm. The particle size refers to a distance from a center of the particle to an outer wall of the particle.

When the surface of the protective film 80 is scratched, the shear force first acts on the anti-reflection layer 81. In the conventional technology, a particle size of the anti-reflection particle 60 in the anti-reflection layer 81 is between 35 nm and 40 nm, and a particle wall thickness of the anti-reflection particle 60 is between 5 nm and 7 nm. In this embodiment of the present invention, by reducing the particle size of the anti-reflection particle 60 and/or increasing the particle wall thickness of the anti-reflection particle 60, a capability of the anti-reflection layer 81 to resist the shear force can be improved, and the shear force can be more quickly dispersed, to avoid scratching a surface of the protective film 80 by external force.

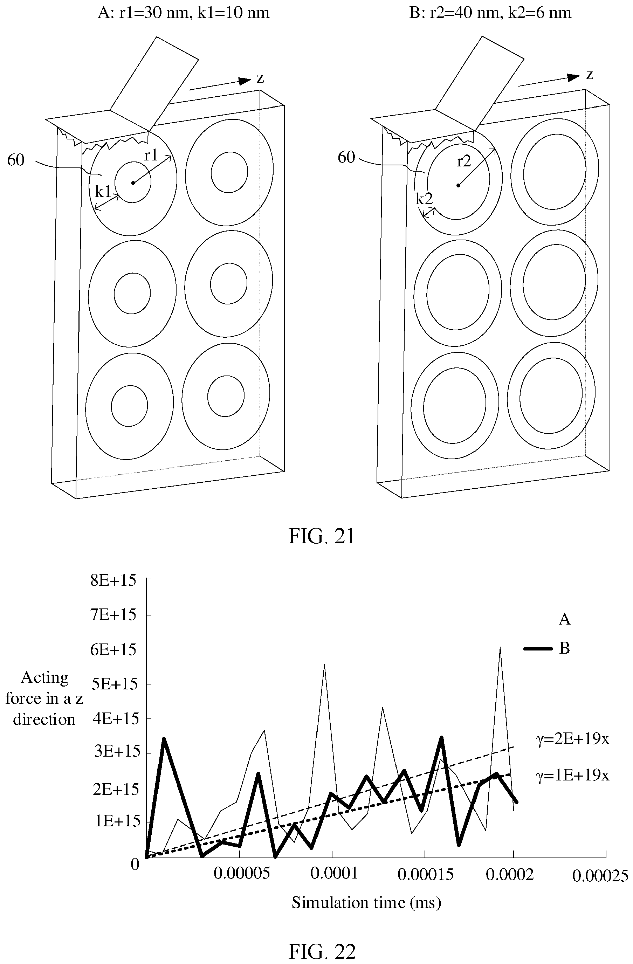

Specifically, FIG. 21 is a schematic diagram of a structural comparison of two anti-reflection layers according to an embodiment of the present invention. As shown in FIG. 21, in an anti-reflection layer A, a particle size r1 of an anti-reflection particle 60 is 30 nm, and a particle wall thickness k1 of the anti-reflection particle 60 is 10 nm. In an anti-reflection layer B, a particle size r2 of an anti-reflection particle 60 is 40 nm, and a particle wall thickness k2 of the anti-reflection particle 60 is 6 nm. When the anti-reflection layer A and the anti-reflection layer B are scraped to a same extent, FIG. 22 is a simulation curve diagram of acting force and simulation time according to an embodiment of the present invention. Two dashed lines in FIG. 22 respectively correspond to linear fitting straight lines of the anti-reflection layer A and the anti-reflection layer B. As shown in FIG. 22, maximum acting force of the anti-reflection layer A in a z direction is about $5\times E^{15}$ to $6\times E^{15}$, and maximum acting force of the anti-reflection layer B in the z direction is about $1\times E^{15}$ to $3\times E^{15}$. It can be learned that abrasion resistance of the anti-reflection layer A is two to three times abrasion resistance of the anti-reflection layer B.

In an implementation, a hardness of the hard coating 52 is h, and 1H≤h≤2H; and/or in a direction perpendicular to a plane on which the substrate 2 is located, a film thickness of the hard coating 52 is D1, and 5 μm≤D1≤8 μm; and/or an elastic modulus of the hard coating 52 is E4, and 80 Gpa≤E4≤100 Gpa. For example, in the protective film 80, a film thickness of the anti-reflection layer 81 is 200 nm, a film thickness of the hard coating 52 is 5 μm, a film thickness of the PET layer 53 is 50 μm, and a film thickness of the optical adhesive layer 54 is 25 μm.

A hardness of the protective film 80 is mainly affected by the hardness of the hard coating 52. By setting the hardness, the film thickness, and the elastic modulus of the hard coating 52 in the foregoing range, an overall hardness of the protective film 80 can be increased, the deflection increment $\Delta W$ of the protective film 80 can be reduced, and a longitudinal (y direction) deformation resistance capability of the protective film 80 can be improved. This further improves scratch resistance performance of the protective film 80 and improves protection effect of the protective film 80 on the display apparatus.

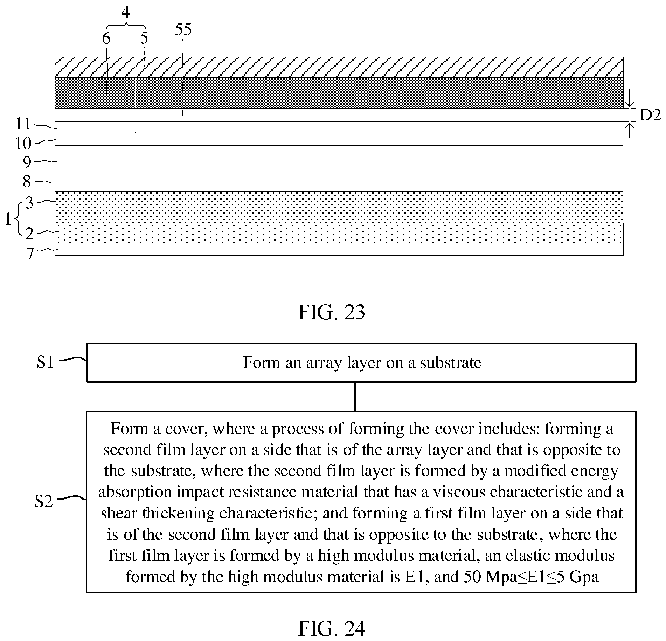

In an implementation, FIG. 23 is a schematic diagram of still another structure of a display apparatus according to an embodiment of the present invention. As shown in FIG. 23, the display apparatus further includes an adhesive layer 55. The adhesive layer 55 is located between the cover 4 and the array layer 3. A glass transition temperature of the adhesive layer 55 is Tg, where Tg≤-40°C, and specifically, -50°C≤Tg≤-40°C. In this case, the glass transition temperature of the adhesive layer 55 is low, so that the adhesive layer 55 has high viscoelasticity in a large temperature range. This improves bending performance of the display apparatus at a low temperature and prolongs a service life.

Further, with reference to Table 1, the adhesive layer solution for forming the adhesive layer 55 is synthesized by using materials with the following mass percentages: a first soft monomer 40% to 66%, a second soft monomer 2% to 8%, an initiator 0.05% to 0.4%, a cross-linking agent 0.05% to 0.5%, a hard monomer 2% to 10%, and a macromolecular polymer 30% to 50%. Glass transition temperatures of the first soft monomer and the second soft monomer are less than or equal to -40°C, and a glass transition temperature of the hard monomer is greater than or equal to 0°C. Therefore, when the first soft monomer and the second soft monomer are used to reduce the glass transition temperature of the entire adhesive layer 55 and improve bonding interface bonding force, the hard monomer and the macromolecular polymer are used to improve stability of a molecular structure of the adhesive layer 55 at a high temperature, and reduce high-temperature creep. It is verified that the adhesive layer 55 formed by the adhesive layer solution can be bent 100,000 times at -20°C.

Table 1

| First soft monomer (mass%) | Second soft monomer (mass%) | Initiator (mass%) | cross-linking agent (mass%) | Hard monomer (mass%) | Macromolecular polymer (mass%) |
|---|---|---|---|---|---|
| 40 to 66 | 2 to 8 | 0.05 to 0.4 | 0.05 to 0.5 | 2 to 10 | 30 to 50 |

Further, the first soft monomer and the second soft monomer separately include one or more of isooctyl acrylate, n-hexyl acrylate, hydroxybutyl acrylate, and n-butyl acrylate. The hard monomer includes at least one of a hydroxyl acrylate monomer, a carboxy acrylate monomer, an amino-acrylate monomer, and a dicyclopentanyl acrylate. The initiator includes a free radical photoinitiator. The free radical photoinitiator may include a pyrolysis photoinitiator and a hydrogen-taking photoinitiator. The types may include but are not limited to 1-hydroxycyclohexyl phenyl ketone, 2-trimethyl benzophenone, 4-trimethyl benzophenone, 6-trimethyl benzophenone, 4-methyl benzophenone, benzophenone, dihydroxydimethylphenylacetone, and the like. The cross-linking agent includes a bifunctional acrylate active polymer, and a molecular weight of the cross-linking agent is greater than or equal to 200 g/mol and less than or equal to 5000 g/mol. A macromolecular polymer is prepared by prepolymerizing the first soft monomer, the second soft monomer, and the hard monomer, and a molecular weight of the macromolecular polymer is greater than or equal to $10 \times 10^4$ g/mol and less than or equal to $100 \times 10^4$ g/mol. For example, the macromolecular polymer includes a macromolecular acrylate prepolymer.

In an implementation, to ensure that the adhesive layer 55 has high viscoelasticity and improve bending performance of the display apparatus, referring to FIG. 23 again, in the direction perpendicular to the plane on which the substrate 2 is located, a film thickness of the adhesive layer 55 is D2, and 15 $\mu$m≤d5≤100 $\mu$m; and/or an elastic modulus of the adhesive layer 55 is E5, and 5 Kpa≤E5≤50 Mpa.

Based on a same inventive concept, an embodiment of the present invention further provides a method for manufacturing a display apparatus according to an embodiment of the present invention. With reference to FIG. 4 and FIG. 5, FIG. 24 is a flowchart of a manufacturing method according to an embodiment of the present invention. As shown in FIG. 24, the manufacturing method includes:

Step S1: Form an array layer 3 on a substrate 2. The substrate 2 and the array layer 3 form an array substrate 1.

Step S2: Forming a cover 4, where a process of forming the cover 4 includes: forming a second film layer 6 on a side that is of the array layer 3 and that is opposite to the substrate 2, where the second film layer 6 is formed by a modified energy absorption impact resistance material that has viscosity and shear thickening behavior; and forming a first film layer 5 on a side that is of the second film layer 6 and that is opposite to the substrate 2, where the first film layer 5 is formed by a high modulus material, an elastic modulus formed by the high modulus material is E1, and 50 Mpa≤E1≤5 Gpa.

The cover 4 formed by using the foregoing manufacturing method is a laminated structure formed by laminating at least the first film layer 5 and the second film layer 6. Specifically, the first film layer 5 has a high elastic modulus and a correspondingly high hardness. The first film layer is disposed on an outer side of the display apparatus. When the display apparatus is impacted or extruded by external force, an impact stress or an extrusion stress first acts on the first film layer 5. In this case, the first film layer 5 with high hardness can improve the scratch resistance performance, prevent a screen of the display apparatus from being scratched, and effectively reduce a deformation under the impact stress or the extrusion stress. This effectively reduces strain of a film layer, such as an inorganic layer, inside the display apparatus. Further, another second film layer 6 that absorbs energy and resists impact and that has the viscosity and the shear thickening behavior is disposed on an inner side of the first film layer 5, so that a buffering effect can be further implemented by using the second film layer 6. The second film layer 6 may convert mechanical energy generated by impact or extrusion into heat energy, and absorb the impact energy or the extrusion energy. In addition, the second film layer 6 has the shear thickening behavior. At a low stress rate, the second film layer 6 keeps a material soft, and has better bending performance. At a high stress rate, an elastic modulus of the second film layer 6 increases, effectively blocking an external impact stress or extrusion stress, and protecting the display apparatus from damage. In addition, the second film layer 6 has the viscosity, to improve adhesion between the second film layer 6 and two adjacent film layers. When the display apparatus is bent or is subjected to external force, a risk of detaching the second film layer 6 can be reduced. This improves reliability of the second film layer 6 in energy absorption and impact resistance.

Therefore, in this embodiment of the present invention, the first film layer 5 and the second film layer 6 are designed, so that the first film layer 5 and the second film layer 6 have different characteristics. Performance cooperation between the first film layer 5 and the second film layer 6 can be used to improve protection performance of the cover 4 for the display apparatus, so that the display apparatus has good impact resistance performance, scratch resistance performance, and bending performance.

It should be noted that forming materials and film thicknesses of the first film layer 5 and the second film layer 6 are described in the foregoing embodiment, and details are not described herein again.

In an implementation, with reference to FIG. 6A, before the second film layer 6 is formed, the process of forming the cover 4 further includes: forming a third film layer 12 on the side that is of the array layer 3 and that is opposite to the substrate 2, where the third film layer 12 is formed by a high modulus material, an elastic modulus formed by the high modulus material is E3, and 50 Mpa≤E3≤5 Gpa. The third film layer 12 with a high modulus is further added to the second film layer 6, and a hardness of the third film layer 12 is correspondingly high, so that large deformation generated by the second film layer 6 can be blocked, to avoid that deformation continues to accumulate to an inner side, and consequently relatively large deformation is also generated on a film layer in the array layer 3, so that the cover 4 has better impact resistance performance.

When the cover 4 includes the first film layer 5, the second film layer 6, and the third film layer 12, an example in which the first film layer 5 is a CPI film, the second film layer 6 is polyborosiloxane modified silicone rubber, and the third film layer 12 is a PET film is used, and the process of forming the cover 4 may specifically include: forming the PET film (the third film layer 12), then dissolving the polyborosiloxane modified silicone rubber in a solvent, coating the solvent on the third film layer 12, attaching the CPI film (the first film layer 5) after the solvent is dried by using hot air, and finally performing curing.

In an implementation, with reference to FIG. 6B, before the second film layer 6 is formed, the process of forming the cover 4 further includes: forming a fourth film layer 44 on the side that is of the array layer 3 and that is opposite to the substrate 2, where the fourth film layer 44 is formed by a modified energy absorption impact resistance material that has viscosity and shear thickening behavior. The fourth film layer 44 formed by the modified energy absorption impact resistance material is further disposed on an inner side of the second film layer 6, so that impact energy or extrusion energy can be further absorbed by using the fourth film layer 44, to achieve better buffering effect, and the cover 4 can have better extrusion resistance performance by using the viscosity and the shear thickening behavior of the fourth film layer 44.

In an implementation, with reference to FIG. 12, a process of forming the array layer 3 includes: forming inorganic insulation layers 13, forming a hollow part 14 in at least one layer of the inorganic insulation layers 13, and filling the hollow part 14 with an organic material to form an organic part 15. Compared with the entire covering inorganic insulation layers 13 in the conventional technology, in this embodiment of the present invention, the hollow part 14 is disposed in the inorganic insulation layer 13, and the hollow part 14 is filled with an organic material, so that stress concentrated in the inorganic insulation layer 13 can be dispersed by using the organic material, to avoid stress accumulates to a crack threshold of the inorganic insulation layer 13, and effectively reduce a risk of breaking the inorganic insulation layer 13 and the metal layer in the array substrate 1. This improves the extrusion resistance performance and the bending performance of the display apparatus, but also avoids bad display phenomena such as broken bright spots and bright lines caused by broken wires of the metal layer.

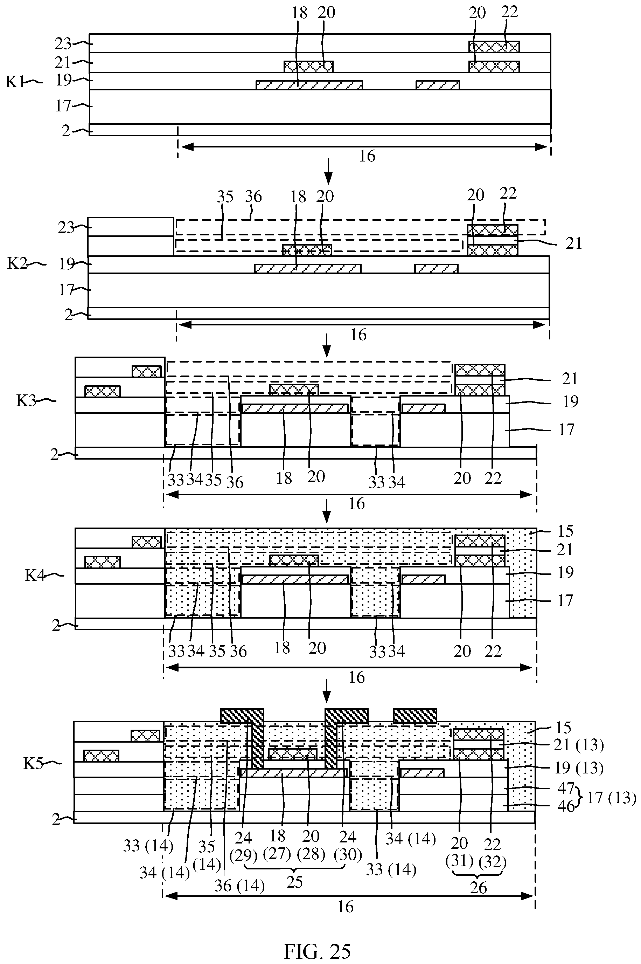

Further, FIG. 25 is a flowchart of a structure of a method for manufacturing an array layer according to an embodiment of the present invention. As shown in FIG. 25, a process of forming the array layer 3 includes:

Step K1: Form a protective layer 17, a semiconductor layer 18, a first gate insulation layer 19, a first gate layer 20, a second gate insulation layer 21, a second gate layer 22, and an interlayer insulation layer 23 in sequence on a substrate 2, where inorganic insulation layers 13 include the protective layer 17, the first gate insulation layer 19, the second gate insulation layer 21, and the interlayer insulation layer 23.

Specifically, step K1 specifically includes:

Step K11: Coat a PI material with a thickness of 9 $\mu$m to 11 $\mu$m on a cleaned glass substrate, and cure the PI material, to form the substrate 2.

Step K12: Deposit an isolation layer 46 with a thickness of 650 nm and an amorphous silicon layer with a thickness of 5 nm on the substrate 2 by using a plasma enhanced chemical vapor deposition (Plasma Enhanced Chemical Vapor Deposition, PECVD) technology, where the isolation layer 46 is configured to absorb laser lift off (laser lift off, LLO) energy when an ELA process is subsequently performed on the amorphous silicon layer.

Step K13: Deposit a buffer layer 47 by using the PECVD technology, where the buffer layer 47 is a composite film layer of a $SiN_x$ with a thickness of 200 nm and $SiO_2$ with a thickness of 350 nm, and the buffer layer 47 is configured to provide a heat preservation function when the ELA process is subsequently performed on the amorphous silicon layer. It should be noted that, before the buffer layer 47 is deposited, with reference to FIG. 13, a PI layer with a thickness of 9 $\mu$m to 11 $\mu$m may be further first formed.

Step K14: Deposit the amorphous silicon layer by using the PECVD technology, perform hydrogen removal processing (450°C, 2h) on the amorphous silicon layer, then perform the ELA process to implement conversion from the amorphous silicon layer to a polycrystalline silicon layer, and perform a process such as exposure, development, and etching on the polycrystalline silicon layer to form the semiconductor layer 18 having a specific pattern.

Step K15: Deposit a first gate insulation layer 19 with a thickness of 120 nm by using the PECVD technology, where the first gate insulation layer 19 may be a $SiO_2$ layer.

Step K16: Deposit a Mo metal layer with a thickness of 220 nm by using a magnetron sputtering (Sputter) technology, and perform a process such as exposure, development, and etching on the Mo metal layer to form the first gate layer 20 with a specific pattern, where the first gate layer 20 is configured to serve as a gate 28 of a transistor 25 and a first electrode plate 31 of a storage capacitor 26.

Step K17: Deposit the second gate insulation layer 21 with a thickness of 130 nm by using the PECVD technology, where the second gate insulation layer 21 may be a $SiN_x$ layer, and the second gate insulation layer 21 is configured to serve as a capacitance medium layer of the storage capacitor 26.

Step K18: Deposit the Mo metal layer with the thickness of 220 nm by using the sputter technology, and perform a process such as exposure, development, and etching on the Mo metal layer to form a second gate layer 22 with a specific pattern, where the second gate layer 22 is configured to serve as a second electrode plate 32 of the storage capacitor 26.

Step K19: Deposit the interlayer insulation layer 23 by using the PECVD technology, where the interlayer insulation layer 23 is a composite film layer formed by a $SiN_x$ layer with a thickness of 300 nm and a lower $SiO_2$ layer with a thickness of 300 nm, and then perform hydrogenation processing (350 degrees Celsius, 2h) to repair a dangling bond on a surface of the polycrystalline silicon.

Step K2: Etch the interlayer insulation layer 23 and the second gate insulation layer 21, to form a fourth hollow part 36 on the interlayer insulation layer 23 and a third hollow part 35 on the second gate insulation layer 21, where in a direction perpendicular to a plane on which the substrate 2 is located, the fourth hollow part 36 covers a display area 16 of the display apparatus, and the third hollow part 35 does not overlap the second gate layer 22.

Step K3: Etch the first gate insulation layer 19 and the protective layer 17 to form a second hollow part 34 on the first gate insulation layer 19 and form a first hollow part 33 on the protective layer 17, where in the direction perpendicular to the plane on which the substrate 2 is located, the second hollow part 34 and the first hollow part 33 do not overlap the semiconductor layer 18 and the first gate layer 20.

Step K4: Fill the first hollow part 33, the second hollow part 34, the third hollow part 35, and the fourth hollow part 36 with an organic material, where an organic part 15 may be an organic material of a polyimide system, or an organic material of a same type as a flattening layer, a pixel definition layer, and a support column, and after the organic material is filled to form the organic part 15, a through hole further needs to be formed on the organic part 15.

It should be noted that, to increase the screen-to-body ratio of the display apparatus and further reduce a width of a frame, an edge part of the array substrate 1 that is located in the non-display area may be bent back (Pad bending) to bind the driver chip. To avoid a crack in the inorganic insulation layer 13 in the bending area in a bending process, the inorganic insulation layer 13 in the bending area may be etched and filled with an organic material. When the inorganic insulation layer 13 in the bending is etched, two etching processes are usually used. Based on this, in this embodiment of the present invention, a pattern of a mask in the first etching process may be adjusted, and both the interlayer insulation layer 23 and the second gate insulation layer 21 are etched in the first etching process; and a pattern of the mask in the second etching process may be adjusted, and both the first gate insulation layer 19 and the protective layer 17 are etched in the second etching process, to simplify a technical process and reduce a quantity of masks that need to be used. In addition, the first hollow part 33, the second hollow part 34, the third hollow part 35, the fourth hollow part 36, and a hollow of a bent area may be filled with an organic material at the same time, to simplify a technical process.

Step K5: Form a source/drain layer 24. The source/drain layer 24 is connected to the semiconductor layer 18 through the through hole in the organic part 15.

Specifically, the source/drain layer 24 is a Ti-Al-Ti composite film layer, and thicknesses of the Ti-Al-Ti composite film layer are 50 nm, 650 nm, and 50 nm respectively. After the composite film layer is deposited, a process such as exposure, development, and etching is performed to form the source/drain layer 24 with a specific pattern. The source/drain layer 24 is used as a source 29 and a drain 30 of the transistor 25, and is configured to transmit a data signal to a light emitting device layer 8, and control light emitting brightness of the light emitting device.

Based on the foregoing disposing manner, the protective layer 17, the first gate insulation layer 19, the second gate insulation layer 21, and the interlayer insulation layer 23 in the plurality of inorganic insulation layers 13 each have the hollow part 14, and the organic part 15 filled in the hollow part 14 is used to improve extrusion resistance performance and bending performance of the display apparatus to a greater extent. In addition, the hollow parts 14 of the protective layer 17, the first gate insulation layer 19, and the second gate insulation layer 21 do not overlap the metal layer or the semiconductor layer 18 on a side that is of the film layer and that is opposite to the substrate 2. In other words, a lower side of the metal layer or the semiconductor layer 18 is still adjacent to the inorganic material, so that the inorganic material can be used to achieve better insulation effect.

In addition, the display apparatus further includes forming a film layer such as a flattening layer 56, a light emitting device layer 8, a packaging layer 9, a polarizer 10, and a touch layer 11. With reference to FIG. 12, a process of forming the flattening layer 56, the light emitting device layer 8, and the packaging layer 9 may specifically include:

Step Q1: Form the flattening layer 56 with a thickness of 1.5 $\mu$m, and perform a process such as exposure, development, and etching on the flattening layer 56, to form a through hole on the flattening layer 56.

Step Q2: Deposit an ITO-Ag-ITO composite film layer, where thicknesses of the composite film layer are respectively 10 nm, 100 nm, and 7 nm, and perform a process such as exposure, development, etching on the composite film layer, to complete preparation of the anode 37.

Step Q3: Form a pixel definition layer 43 (pixel definition layer, PDL) with a thickness of 1.5 μm, and perform a process such as exposure, development, and etching on the pixel definition layer 43 to form an opening.

Step Q4: Form a support column 45 with a thickness of 2 μm, where the support column 45 is configured to support the FMM during subsequent vapor deposition of a light emitting layer 38.

Step Q5: Form the light emitting layer 38 with a thickness of 300 nm and a cathode 39 with a thickness of 12 nm, and perform vapor deposition on the light emitting layer 38 and the cathode 39 to form an optical coupling layer (coupling layer, CPL) and a LiF layer, where the CPL layer is an organic layer, and is configured to adjust a refractive index and increase light output efficiency, and the LiF layer is an inorganic layer, and is configured to perform electromagnetic shielding.

Step Q6: Form a first inorganic packaging layer 40 with a thickness of 1 μm, where the first inorganic packaging layer 40 may be a SiON layer, then coat an organic material to form an organic packaging layer 41 with a thickness of 10 μm, and finally form a second inorganic packaging layer 42 with a thickness of 1 μm, where the second inorganic packaging layer 42 may be a SiOx layer, and the first inorganic packaging layer 40, the organic packaging layer 41, and the second inorganic packaging layer 42 form a packaging layer 9.

In an implementation, with reference to FIG. 18, after the cover 4 is formed, the manufacturing method further includes: forming a protective film 80 including an anti-reflection layer 81. A process of forming the anti-reflection layer 81 includes: forming a core microsphere/microemulsion through self-assembly or by using a surfactant, preparing a silicon dioxide shell layer on a surface of the core microsphere by using a sol-gel method, and then repeatedly cleaning and taking away the core microsphere by using a solvent to form hollow silicon dioxide, where the hollow silicon dioxide is an anti-reflection particle 60, a particle size of the hollow silicon dioxide is r, 25 nm≤r≤30 nm, and/or a particle wall thickness of the hollow silicon dioxide is k, and 10 nm≤k≤12 nm. A capability of the anti-reflection layer 81 to resist shear force is improved by reducing the particle size of the anti-reflection particle 60 and increasing the particle wall thickness of the anti-reflection particle 60, so that the shear force is more quickly dispersed, and a surface of the protective film 80 is prevented from being scratched by external force.

Further, a process of forming a core microsphere/microemulsion through self-assembly or by using a surfactant, preparing a silicon dioxide shell layer on a surface of the core microsphere by using a sol-gel method, and then repeatedly cleaning and taking away the core microsphere by using a solvent to form hollow silicon dioxide may specifically include:

Step H1: Disperse 0.3 g to 0.5 g polyacrylic acid into 15 ml to 20 ml ammonia water for mixing, until the polyacrylic acid is completely and evenly distributed into the ammonia water.

Step H2: Pour the ammonia polyacrylic acid solution into anhydrous ethanol beaker, and after the ammonia polyacrylic acid solution is evenly dispersed, stir the beaker by magnetic force while slowly adding ethyl silicate with a total amount of 2 ml to 3 ml.

Step H3: After the ethyl silicate is added, continue to stir the mixed solution at a room temperature for 10 hours, to finally form a transparent solution of hollow spherical silicon dioxide sol.

Step H4: Hybridize the hollow spherical silicon dioxide sol. First, perform condensation reflow at about 80° on the silicon oxide nanoparticle sol to remove ammonia water from the solution. After cooling to the room temperature, add diluted hydrochloride for PH value adjustment. Finally, adjust the PH value to about 2 to 3. Finally, add 1 to 2 ml ethyl silicate to the solution and stir the solution for 1 hour to 2 hours.

Step H5: Prepare an anti-reflection coating: perform solution coating on a PET substrate (or a PET substrate with HC coating), and control a final film thickness between 150 nm and 200 nm by using a spin coating process at the room temperature by adjusting a rotation speed and a quantity of coating times.

Step H6: After the film coating is completed, use about 30% peroxide water to perform soaking and heating to 80 to 100° to remove ethyl silicate in the solution, and form a dense hollow silicon oxide coating, that is, the anti-reflection layer 81.

In an implementation, with reference to FIG. 18, before the anti-reflection layer 81 is formed, a process of forming the protective film 80 further includes: forming a hard coating 52, where a hardness of the hard coating 52 is h, and 1H≤h≤2H; and/or in a direction perpendicular to a plane on which the substrate 2 is located, a film thickness of the hard coating 52 is d4, and 5 μm≤d4≤8 μm; and/or an elastic modulus of the hard coating 52 is E4, and 80 Gpa≤E4≤100 Gpa.

A hardness of the protective film 80 is mainly affected by the hardness of the hard coating 52. By setting the hardness, the film thickness, and the elastic modulus of the hard coating 52 in the foregoing range, an overall hardness of the protective film 80 can be increased, the deflection increment $\Delta W$ of the protective film 80 can be reduced, and a longitudinal deformation resistance capability of the protective film 80 can be improved. This further improves scratch resistance performance of the protective film 80 and improves protection effect of the protective film 80 on the display apparatus.

A process of forming the hard coating 52 includes:

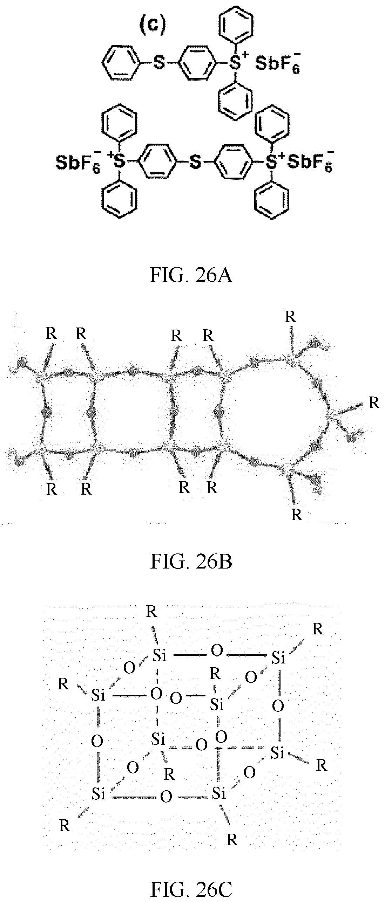

Step G1: Mix a cationic initiator such as sulfonium salt with methyl ladder-like polyhedral oligomeric silsesquioxane or cage-like polyhedral oligomeric silsesquioxane at a proportion of 3% and 97%, and then mix the obtained mixture with tetrahydrofuran at a ratio of 1 to 2 and stir the mixture evenly. FIG. 26A shows a molecular structure of the sulfonium salt, FIG. 26B shows an analytical structure of the methyl ladder-like polyhedral oligomeric silsesquioxane, and FIG. 26C shows a molecular structure of the cage-like polyhedral oligomeric silsesquioxane.

Step G2: Coat a solution on the PET layer by using a 5 $\mu$m screw rod, and a coating speed is about 5 mm/s to 10 mm/s.

Step G3: Heat and remove the solvent in a vacuum environment. Specifically, a heating temperature is between 25°C and 80°C, and heating time is 5 minutes to 10 minutes.

Step G4: Perform UV curing for 15 minutes to 20 minutes, and UV energy is 1 j/cm2 to 3 j/cm2. During the curing process, a photoinitiator generates a large amount of H, and causes an epoxy group to undergo a polymerization reaction in an ACE (active-chain end) mode. As an active center of the epoxy group gradually decreases, the polymerization reaction gradually stops, and a conversion rate reaches saturation.

Step G5: Perform damp and heat annealing treatment, where a condition is a temperature 60°C and a humidity 90%, and time is 2 hours. The introduction of moisture annealing can make $R_3O^+$ on the epoxy group react with water molecules, and generate -OH and an H+ at the end. The new generated H+ and a neutral epoxy group react to generate active secondary $R_2HO^+$, so that the ACE reaction is repeated, and the polymerization is increased until the film is formed to form the hard coating 52.

In an implementation, with reference to FIG. 23, before the second film layer 6 is formed, the manufacturing method further includes forming an adhesive layer 55.

A process of forming the adhesive layer 55 includes: configuring an adhesive layer solution and preparing the adhesive layer 55 by using the configured adhesive layer solution, where the adhesive layer solution is synthesized by materials with the following mass percentages: a first soft monomer 40% to 66%, a second soft monomer 2% to 8%, an initiator 0.05% to 0.4%, a cross-linking agent 0.05% to 0.5%, a hard monomer 2% to 10%, and a macromolecular polymer 30% to 50%, and glass transition temperatures of the first soft monomer and the second soft monomer are less than or equal to -40°C, and a glass transition temperature of the hard monomer is greater than or equal to 0°C. In this case, the glass transition temperature of the adhesive layer 55 is low, so that the adhesive layer 55 has high viscoelasticity in a large temperature range. This improves bending performance of the display apparatus at a low temperature and prolongs a service life.

A process of configuring the adhesive layer solution includes:

Step W1: Use a first soft monomer (for example, isooctyl acrylate) as a solution diluting initiator and a cross-linking agent, and separately configure an initiator solution and a cross-linking agent solution with a concentration of 1%.

Step W2: Dissolve the first soft monomer (for example, isooctyl acrylate) by using a mixing paddle or a reaction kettle based on a ratio to dilute a dilute macromolecular polymer (for example, a modified acrylate prepolymer).

Step W3: Configure, based on a ratio, an adhesive solution by using the initiator solution obtained after the second soft monomer (for example, hydroxybutyl acrylate), the hard monomer (for example, dicyclopentanyl acrylate), and the first soft monomer (for example, isooctyl acrylate) are diluted. It should be noted that an actually added solution mass may be 100 times the value in Table 1.

Step W4: Illuminate the gel under an ultraviolet light with a wavelength of about 365 nm, observe and measure viscosity of the gel in real time, and stop illuminating when the viscosity is about 4000 cps to 6000 cps.

Step W5: Add, based on a ratio, a cross-linking agent solution diluted by using the first soft monomer (for example, isooctyl acrylate) into the solution, and stir the solution to form the adhesive layer solution.

A process of preparing the adhesive layer 55 includes:

Step R1: Set a gasket thickness or a scraper gap of a coating machine based on a thickness requirement of the adhesive layer.

Step R2: Coat the prepared adhesive layer solution on a membrane material such as a release film or a PET film by using a coating screw or the coating machine.

Step R3: Attach the membrane material such as the release film or the PET film to the coated adhesive layer solution.

Step R4: Illuminate the adhesive layer under an ultraviolet light with a wavelength of 365 nm for 1 minute to 5 minutes until the adhesive layer is cured.

The foregoing descriptions are merely example embodiments of the present invention, but are not intended to limit the present invention. Any modification, equivalent replacement, or improvement made within the spirit and principle of the present invention should fall within the protection scope of the present invention.

Finally, it should be noted that the foregoing embodiments are merely intended for describing the technical solutions of the present invention, but not for limiting the present invention. Although the present invention is described in detail with reference to the foregoing embodiments, a person of ordinary skill in the art should understand that they may still make modifications to the technical solutions described in the foregoing embodiments or make equivalent replacements to some or all technical features thereof, without departing from the scope of the technical solutions of embodiments of the present invention.

**Claims**

1. A display apparatus, comprising:

    an array substrate, wherein the array substrate comprises a substrate and an array layer located on a side of the substrate; and
    a cover, wherein the cover is located on a side that is of the array layer and that is opposite to the substrate, the cover comprises a first film layer and a second film layer, and the first film layer is located on a side that is of the second film layer and that is opposite to the substrate, wherein
    the first film layer is formed by a high modulus material, an elastic modulus of the high modulus material is E1, 50 Mpa≤E1≤5 Gpa, and the second film layer is formed by a modified energy absorption impact resistance material that has viscosity and shear thickening behavior.

2. The display apparatus of claim 1, wherein
the modified energy absorption impact resistance material comprises modified silicone rubber, modified thermoplastic polyurethane, modified polyurethane, or a modified shear thickening material.

3. The display apparatus of claim 1, wherein
a molecular structure of the modified energy absorption impact resistance material comprises a bonded polymer molecular main chain and a modified polymer molecular main chain, wherein the modified polymer molecular main chain has a hydrogen bond or a coordination bond, and the coordination bond comprises a boron-oxygen bond, a metal-catechol, or a metal-histidine.

4. The display apparatus of claim 1, wherein
an elastic modulus of the second film layer is E2, and 10 Kpa≤E2≤500 Mpa.

5. The display apparatus of claim 1, wherein
a film thickness of the first film layer is less than a film thickness of the second film layer in a direction perpendicular to a plane on which the substrate is located.

6. The display apparatus of claim 1, wherein
the cover further comprises a third film layer, the third film layer is located on a side that is of the second film layer and that faces the substrate, the third film layer is formed by a high modulus material, an elastic modulus formed by the high modulus material is E3, and 50 Mpa≤E3≤5 Gpa.

7. The display apparatus of claim 1, wherein
the cover further comprises a fourth film layer, the fourth film layer is located on a side that is of the second film layer and that faces the substrate, and the fourth film layer is formed by a modified energy absorption impact resistance material that has viscosity and shear thickening behavior.

8. The display apparatus of claim 1, wherein
the array layer comprises inorganic insulation layers, at least one layer of the inorganic insulation layers has a hollow part, and the hollow part is filled with an organic part.

9. The display apparatus of claim 8, wherein

the array layer comprises a protective layer, a semiconductor layer, a first gate insulation layer, a first gate layer, a second gate insulation layer, a second gate layer, an interlayer insulation layer, and a source/drain layer that are disposed opposite to the substrate in a laminated manner, and the inorganic insulation layer comprises the protective layer, the first gate insulation layer, the second gate insulation layer, and the interlayer insulation layer, wherein

the protective layer has a first hollow part, and the first hollow part does not overlap the semiconductor layer in a direction perpendicular to a plane on which the substrate is located;

the first gate insulation layer has a second hollow part, and the second hollow part does not overlap the first gate layer in the direction perpendicular to the plane on which the substrate is located;

the second gate insulation layer has a third hollow part, and the third hollow part does not overlap the second gate layer in the direction perpendicular to the plane on which the substrate is located; and

the interlayer insulation layer has a fourth hollow part, the display apparatus comprises a display area, and the fourth hollow part covers the display area in the direction perpendicular to the plane on which the substrate is located.

10. The display apparatus of claim 8, wherein
the display apparatus comprises a display area and a non-display area, the non-display area comprises a shift register circuit area and a fan-shaped cabling area, the hollow part is located in the display area and the shift register circuit area, and the hollow part does not overlap the fan-shaped cabling area in a direction perpendicular to a plane on which the substrate is located.

11. The display apparatus of claim 1, wherein

the display apparatus further comprises a protective film, and the protective film is located on a side that is of the cover and that is opposite to the substrate; and

the protective film comprises an anti-reflection layer, the anti-reflection layer comprises a hollow anti-reflection particle, a particle size of the anti-reflection particle is r, and 25 nm$\leq$r$\leq$30 nm; and/or a particle wall thickness of the anti-reflection particle is k, and 10 nm$\leq$k$\leq$12 nm.

12. The display apparatus of claim 11, wherein

the protective film further comprises a hard coating, and the hard coating is located between the anti-reflection layer and the cover; and

a hardness of the hard coating is h, and 1 H$\leq$h$\leq$2 H; and/or in a direction perpendicular to a plane on which the substrate is located, a film thickness of the hard coating is D1, and 5 $\mu$m$\leq$D1$\leq$8 $\mu$m; and/or an elastic modulus of the hard coating is E4, and 80 Gpa$\leq$E4$\leq$100 Gpa.

13. The display apparatus of claim 1, wherein
the display apparatus further comprises an adhesive layer, the adhesive layer is located between the cover and the array layer, a glass transition temperature of the adhesive layer is Tg, and Tg$\leq$-40°C.

14. The display apparatus of claim 13, wherein

an adhesive layer solution forming the adhesive layer is synthesized by materials with the following mass percentages: a first soft monomer 40% to 66%, a second soft monomer 2% to 8%, an initiator 0.05% to 0.4%, a cross-linking agent 0.05% to 0.5%, a hard monomer 2% to 10%, and a macromolecular polymer 30% to 50%; and

glass transition temperatures of the first soft monomer and the second soft monomer are less than or equal to -40°C, and a glass transition temperature of the hard monomer is greater than or equal to 0°C.

15. The display apparatus of claim 14, wherein

the first soft monomer and the second soft monomer separately comprise one or more of isooctyl acrylate, n-hexyl acrylate, hydroxybutyl acrylate, and n-butyl acrylate;

the hard monomer comprises at least one of a hydroxyl acrylate monomer, a carboxy acrylate monomer, an amino-acrylate monomer, and a dicyclopentanyl acrylate;

the initiator comprises a free radical photoinitiator;

the cross-linking agent comprises a bifunctional acrylate active polymer, and a molecular weight of the cross-linking agent is greater than or equal to 200 g/mol and less than or equal to 5000 g/mol; and
the macromolecular polymer is prepared by prepolymerizing the first soft monomer, the second soft monomer, and the hard monomer, and a molecular weight of the macromolecular polymer is greater than or equal to $10 \times 10^4$ g/mol and less than or equal to $100 \times 10^4$ g/mol.

16. The display apparatus of claim 13, wherein
in a direction perpendicular to a plane on which the substrate is located, a film thickness of the adhesive layer is D2, and 15 $\mu$m$\leq$D2$\leq$100 $\mu$m; and/or an elastic modulus of the adhesive layer is E5, and 5 Kpa$\leq$E5$\leq$50 Mpa.

17. A method for manufacturing a display apparatus, comprising:

forming an array layer on a substrate; and
forming a cover, wherein a process of forming the cover comprises: forming a second film layer on a side that is of the array layer and that is opposite to the substrate, wherein the second film layer is formed by a modified energy absorption impact resistance material that has viscosity and shear thickening behavior; and forming a first film layer on a side that is of the second film layer and that is opposite to the substrate, wherein the first film layer is formed by a high modulus material, an elastic modulus formed by the high modulus material is E1, and 50 Mpa$\leq$E1$\leq$5 Gpa.

18. The manufacturing method of claim 17, wherein
before the second film layer is formed, the process of forming the cover further comprises: forming a third film layer on the side that is of the array layer and that is opposite to the substrate, wherein the third film layer is formed by a high modulus material, an elastic modulus formed by the high modulus material is E3, and 50 Mpa$\leq$E3$\leq$5 Gpa.

19. The manufacturing method of claim 17, wherein
before the second film layer is formed, the process of forming the cover further comprises: forming a fourth film layer on the side that is of the array layer and that is opposite to the substrate, wherein the fourth film layer is formed by a modified energy absorption impact resistance material that has viscosity and shear thickening behavior.

20. The manufacturing method of claim 17, wherein
a process of forming the array layer comprises: forming inorganic insulation layers, forming a hollow part in at least one layer of the inorganic insulation layers, and filling the hollow part with an organic material to form an organic part.

21. The manufacturing method of claim 20, wherein
the process of forming the array layer comprises:

sequentially forming a protective layer, a semiconductor layer, a first gate insulation layer, a first gate layer, a second gate insulation layer, a second gate layer, and an interlayer insulation layer on the substrate, wherein the inorganic insulation layer comprises the protective layer, the first gate insulation layer, the second gate insulation layer, and the interlayer insulation layer;
etching the interlayer insulation layer and the second gate insulation layer, to form a fourth hollow part on the interlayer insulation layer and a third hollow part on the second gate insulation layer, wherein in a direction perpendicular to a plane on which the substrate is located, the fourth hollow part covers a display area of the display apparatus, and the third hollow part does not overlap the second gate layer;
etching the first gate insulation layer and the protective layer, to form a second hollow part on the first gate insulation layer and a first hollow part on the protective layer, wherein the second hollow part and the first hollow part do not overlap the semiconductor layer and the first gate layer in the direction perpendicular to the plane on which the substrate is located;
filling the first hollow part, the second hollow part, the third hollow part, and the fourth hollow part with the organic material; and
forming a source/drain layer.

22. The manufacturing method of claim 17, wherein

after the cover is formed, the manufacturing method further comprises: forming a protective film comprising an anti-reflection layer; and
a process of forming the anti-reflection layer comprises: forming a core microsphere/microemulsion through self-assembly or by using a surfactant, preparing a silicon dioxide shell layer on a surface of the core microsphere by using a sol-gel method, and then repeatedly cleaning and taking away the core microsphere by using solvent, to form hollow silicon dioxide, wherein a particle size of the hollow silicon dioxide is r, 25 nm≤r≤30 nm, and/or a particle wall thickness of the hollow silicon dioxide is k, and 10 nm≤k≤12 nm.

23. The manufacturing method of claim 22, wherein
before the anti-reflection layer is formed, a process of forming the protective film further comprises: forming a hard coating, wherein a hardness of the hard coating is h, and 1 H≤h≤2 H; and/or in a direction perpendicular to a plane on which the substrate is located, a film thickness of the hard coating is d4, and 5 $\mu$m<d4≤8 $\mu$m; and/or an elastic modulus of the hard coating is E4, and 80 Gpa≤E4≤100 Gpa.

24. The manufacturing method of claim 17, wherein

before the second film layer is formed, the manufacturing method further comprises: forming an adhesive layer; and

a process of forming the adhesive layer comprises: configuring an adhesive layer solution, and preparing the adhesive layer by using the configured adhesive layer solution, wherein the adhesive layer solution is synthesized by materials with the following mass percentages: a first soft monomer 40% to 66%, a second soft monomer 2% to 8%, an initiator 0.05% to 0.4%, a cross-linking agent 0.05% to 0.5%, a hard monomer 2% to 10%, and a macromolecular polymer 30% to 50%; and glass transition temperatures of the first soft monomer and the second soft monomer are less than or equal to -40°C, and a glass transition temperature of the hard monomer is greater than or equal to 0°C.

105  106  107

104
103

102
101

108

FIG. 1

104

120  121  122

103
102 { 110
     111
101 { 110
     109

FIG. 2

119
118
117
103 { 116
115
114
113
102

FIG. 3

FIG. 4

FIG. 5

FIG. 6A

FIG. 6B

104
122 121 120

103
119 116 113

102

123 123 123    124    124 124    A

FIG. 7

124

124

123

123

123

124

FIG. 8

FIG. 9

FIG. 10

107

102

110

101 { 125

109

FIG. 11

FIG. 12

FIG. 13

FIG. 14

FIG. 15

FIG. 16

33 (14)  34 (14) 24  18  20  35 (14) 36 (14)  22  15

49 (51)  16  49 (50)

FIG. 17

4  80  60
6  5  81  52  53  54

D1

11
10
9
8
3
1
2
7

FIG. 18

FIG. 19

FIG. 20

A: r1=30 nm, k1=10 nm    B: r2=40 nm, k2=6 nm

FIG. 21

FIG. 22

FIG. 23

| S1 | Form an array layer on a substrate |
|---|---|

| S2 | Form a cover, where a process of forming the cover includes: forming a second film layer on a side that is of the array layer and that is opposite to the substrate, where the second film layer is formed by a modified energy absorption impact resistance material that has a viscous characteristic and a shear thickening characteristic; and forming a first film layer on a side that is of the second film layer and that is opposite to the substrate, where the first film layer is formed by a high modulus material, an elastic modulus formed by the high modulus material is E1, and 50 Mpa≤E1≤5 Gpa |
|---|---|

FIG. 24

FIG. 25

FIG. 26A

FIG. 26B

FIG. 26C

## INTERNATIONAL SEARCH REPORT

| International application No. |
| --- |
| **PCT/CN2022/090940** |

| A. | CLASSIFICATION OF SUBJECT MATTER |
| --- | --- |

H01L 27/32(2006.01)i; H01L 51/52(2006.01)i; H01L 51/56(2006.01)i

According to International Patent Classification (IPC) or to both national classification and IPC

| B. | FIELDS SEARCHED |
| --- | --- |

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT: 显示, 盖板, 盖窗, 剪切增稠, 无机, 有机, display, cap, cover, shear thickening, inorganic, organic

| C. | DOCUMENTS CONSIDERED TO BE RELEVANT | | |
| --- | --- | --- | --- |
| Category* | Citation of document, with indication, where appropriate, of the relevant passages | | Relevant to claim No. |
| Y | CN 107545847 A (SAMSUNG DISPLAY CO., LTD.) 05 January 2018 (2018-01-05) description, paragraphs [0030]-[0068], and figures 1-5 | | 1-24 |
| Y | CN 111312782 A (BOE TECHNOLOGY GROUP CO., LTD.) 19 June 2020 (2020-06-19) description, paragraphs [0036]-[0061], and figure 12 | | 1-24 |
| A | CN 109103224 A (YUNGU (GU'AN) TECHNOLOGY CO., LTD.) 28 December 2018 (2018-12-28) entire document | | 1-24 |
| A | CN 106601776 A (WUHAN CHINA STAR OPTOELECTRONICS TECHNOLOGY CO., LTD.) 26 April 2017 (2017-04-26) entire document | | 1-24 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **07 June 2022** | **24 June 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/090940**

| Patent document cited in search report | | | Publication date (day/month/year) | Patent family member(s) | | | Publication date (day/month/year) |
|---|---|---|---|---|---|---|---|
| CN | 107545847 | A | 05 January 2018 | KR | 20180002114 | A | 08 January 2018 |
| | | | | US | 2017373281 | A1 | 28 December 2017 |
| | | | | US | 9865844 | B1 | 09 January 2018 |
| | | | | CN | 107545847 | B | 08 February 2022 |
| CN | 111312782 | A | 19 June 2020 | WO | 2021169575 | A1 | 02 September 2021 |
| CN | 109103224 | A | 28 December 2018 | KR | 20200066727 | A | 10 June 2020 |
| | | | | US | 2020194526 | A1 | 18 June 2020 |
| | | | | WO | 2020038018 | A1 | 27 February 2020 |
| CN | 106601776 | A | 26 April 2017 | | None | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110665834